# EUROPEAN PATENT APPLICATION

(11) **EP 4 006 123 A1**
(43) Date of publication of application: **01.06.2022**
(21) Application number: 20844345.7
(22) Date of filing: 16.06.2020
(51) Int. Cl.: C09K 11/06, C07F 5/02, H01L 51/00, H01L 51/50, H01L 51/52, H01L 51/56

(54) **ORGANIC ELECTROLUMINESCENT COMPOUNDS AND ORGANIC ELECTROLUMINESCENT DEVICE**

(30) Priority: 23.07.2019 KR 20190088817; 05.06.2020 KR 20200068300
(71) Applicant: SFC Co., Ltd., Cheongju-si, Chungcheongbuk-do 28122 (KR)
(72) Inventor: SHIM, So-young, Cheongju-si Chungcheongbuk-do 28122 (KR); YU, Se-Jin, Cheongju-si Chungcheongbuk-do 28122 (KR)
(74) Representative: Grosse, Felix Christopher
(86) International application number: PCT/KR2020/007758
(87) International publication number: WO 2021/015417

(57) **Abstract**

The present invention relates to a polycyclic aromatic derivative and an electroluminescent device comprising same. The electroluminescent device according to the present invention comprises a polycyclic aromatic derivative as a dopant compound in a light-emitting layer thereof and also employs an anthracene derivative having a characteristic structure, as a host in combination therewith, in the light-emitting layer, whereby the electroluminescent device can have excellent color purity, high light-emitting efficiency, and a remarkably improved long lifespan, and thus can be advantageously used in various display devices.

## Description

The present invention relates to polycyclic aromatic derivatives as organic electroluminescent compounds and organic electroluminescent devices. More specifically, the present invention relates to organic electroluminescent devices in which a combination of a polycyclic aromatic derivative as a dopant compound and an anthracene derivative as a host compound is employed in a light emitting layer, achieving high luminous efficiency, high color purity, and significantly improved lifetime.

Organic electroluminescent devices are self-luminous devices in which electrons injected from an electron injecting electrode (cathode) recombine with holes injected from a hole injecting electrode (anode) in a light emitting layerto form excitons, which emit light while releasing energy. Such organic electroluminescent devices have the advantages of low driving voltage, high luminance, large viewing angle, and short response time and can be applied to full-color light emitting flat panel displays. Due to these advantages, organic electroluminescent devices have received attention as next-generation light sources.

The above characteristics of organic electroluminescent devices are achieved by structural optimization of organic layers of the devices and are supported by stable and efficient materials for the organic layers, such as hole injecting materials, hole transport materials, light emitting materials, electron transport materials, electron injecting materials, and electron blocking materials. However, more research still needs to be done to develop structurally optimized structures of organic layers for organic electroluminescent devices and stable and efficient materials for organic layers of organic electroluminescent devices.

Particularly, for maximum efficiency in a light emitting layer, an appropriate combination of energy band gaps of a host and a dopant is required such that holes and electrons migrate to the dopant through stable electrochemical paths to form excitons.

### Problems to be Solved by the Invention

Thus, the present invention intends to provide a polycyclic aromatic derivative as an organic electroluminescent compound and an organic electroluminescent device in which a combination of the polycyclic aromatic derivative as a dopant compound and a specific host material is employed in a light emitting layer, achieving improved luminescent properties such as high color purity, high luminous efficiency, and long lifetime.

### Means for Solving the Problems

One aspect of the present invention provides an organic electroluminescent compound represented by Formula A: 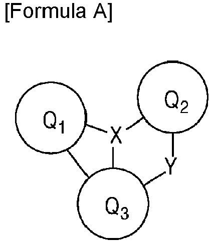 as defined in the appended claims.

A further aspect of the present invention provides an organic electroluminescent device including a first electrode, a second electrode opposite to the first electrode, and a light emitting layer interposed between the first and second electrodes wherein the light emitting layer includes the compound represented by Formula A as defined in the appended claims.

Another aspect of the present invention provides an organic electroluminescent device including a light emitting layer employing a combination of a dopant compound represented by Formula A: 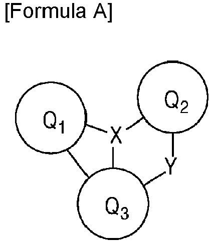 and a host compound represented by Formula H1: 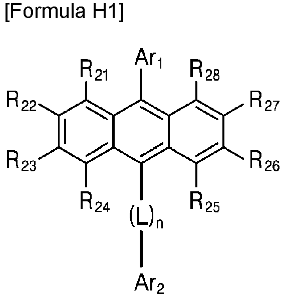 as defined in the appended claims or Formula H2: 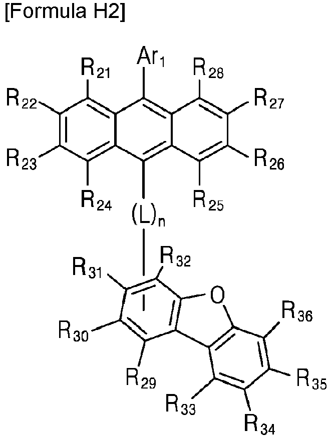 as defined in the appended claims.

The structures of Formulae A, H1, and H2 are described below and the substituents in Formulae A, H1, and H2 are as defined below.

### Effects of the Invention

The organic electroluminescent device of the present invention includes a light emitting layer employing a combination of (1) a polycyclic aromatic derivative as a dopant compound and (2) an anthracene derivative with a specific structure as a host compound. The use of the dopant and host compounds ensures high purity, high luminous efficiency, and significantly improved longtime. Due to these advantages, the organic electroluminescent device of the present invention can find useful applications in a variety of displays.

The present invention will now be described in more detail.

The present invention is directed to a polycyclic aromatic derivative as an organic electroluminescent compound, represented by Formula A: 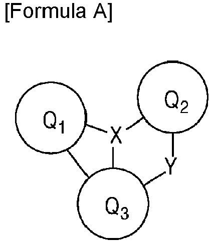 wherein Q₁ to Q₃ are identical to or different from each other and are each independently a substituted or unsubstituted C₆-C₅₀ aromatic hydrocarbon ring or a substituted or unsubstituted C₂-C₅₀ aromatic heterocyclic ring, Y is a single bond or is selected from NR₁, CR₂R₃, O, S, and SiR₄R₅, provided that when Y is present in plurality, the linkers Y are identical to or different from each other, X is selected from B, P, P=O and P=S, and R₁ to R₅ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that each of R₁ to R₅ is optionally bonded to one or more of the rings Q₁ to Q₃ to form an alicyclic or aromatic monocyclic or polycyclic ring, R₂ and R₃ are optionally linked together to form an alicyclic or aromatic monocyclic or polycyclic ring, and R₄ and R₅ are optionally linked together to form an alicyclic or aromatic monocyclic or polycyclic ring.

According to a preferred embodiment of the present invention, X in Formula A is boron (B). The structure of the polycyclic aromatic derivative represented by Formula A wherein X is selected from B, P, P=O, and P=S enables the fabrication of a high-efficiency, long-lasting organic electroluminescent device.

According to one embodiment of the present invention, each of R₁ to R₅ are optionally bonded to one or more of the rings Q₂ and Q₃ to form an alicyclic or aromatic monocyclic or polycyclic ring.

According to one embodiment of the present invention, the organic electroluminescent compound of Formula A is represented by Formula A-1: 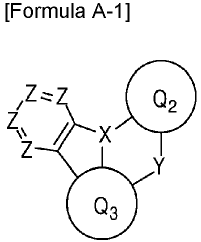 wherein each Z is independently CR or N, each R is independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that the groups R are optionally bonded to each other to form an alicyclic or aromatic monocyclic or polycyclic ring or each of the groups R is optionally linked to an adjacent substituent to form an alicyclic or aromatic monocyclic or polycyclic ring and that the alicyclic or aromatic monocyclic or polycyclic ring is optionally interrupted by one or more heteroatoms selected from N, S, and O, and X, Y, Q₂, and Q₃ are as defined in Formula A.

The polycyclic aromatic skeleton of Formula A-1 and the introduced substituents in Formula A-1 meet desired requirements for organic layers of an organic electroluminescent device, making the organic electroluminescent device highly efficient and long lasting.

According to one embodiment of the present invention, the organic electroluminescent compound of Formula A-1 is represented by Formula A-2: 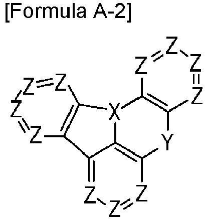 wherein X, Y, and Z are as defined in Formula A-1.

The polycyclic aromatic skeleton of Formula A-2 and the introduced substituents in Formula A-2 meet desired requirements for organic layers of an organic electroluminescent device, making the organic electroluminescent device highly efficient and long lasting.

According to one embodiment of the present invention, the organic electroluminescent compound of Formula A is represented by Formula B-1: 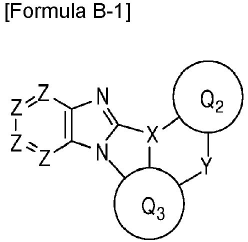 wherein each Z is independently CR or N, each R is independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that the groups R are optionally bonded to each other to form an alicyclic or aromatic monocyclic or polycyclic ring or each of the groups R is optionally linked to an adjacent substituent to form an alicyclic or aromatic monocyclic or polycyclic ring and that the alicyclic or aromatic monocyclic or polycyclic ring is optionally interrupted by one or more heteroatoms selected from N, S, and O, and X, Y, Q₂, and Q₃ are as defined in Formula A.

The polycyclic aromatic skeleton of Formula B-1 and the introduced substituents in Formula B-1 meet desired requirements for organic layers of an organic electroluminescent device, making the organic electroluminescent device highly efficient and long lasting.

According to one embodiment of the present invention, the organic electroluminescent compound of Formula B-1 is represented by Formula B-2: 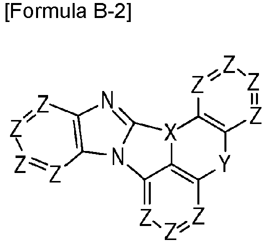 wherein X, Y, and Z are as defined in Formula B-1.

The polycyclic aromatic skeleton of Formula B-2 and the introduced substituents in Formula B-2 meet desired requirements for organic layers of an organic electroluminescent device, making the organic electroluminescent device highly efficient and long lasting.

According to one embodiment of the present invention, at least one of the groups R is other than hydrogen and deuterium. That is, at least one of the groups R is selected from substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen.

As used herein, the term "substituted" in the definition of Q₁ to Q₃ and R₁ to R₅ in Formula A, R, Q₂, and Q₃ in Formula A-1, R in Formula A-2, R, Q₂, and Q₃ in Formula B-1, and R in Formula B-2 indicates substitution with one or more substituents selected from deuterium, cyano, halogen, hydroxyl, nitro, C₁-C₂₄ alkyl, C₃-C₂₄ cycloalkyl, C₁-C₂₄ haloalkyl, C₁-C₂₄ alkenyl, C₁-C₂₄ alkynyl, C₁-C₂₄ heteroalkyl, C₁-C₂₄ heterocycloalkyl, C₆-C₂₄ aryl, C₆-C₂₄ arylalkyl, C₂-C₂₄ heteroaryl, C₂-C₂₄ heteroarylalkyl, C₁-C₂₄ alkoxy, C₁-C₂₄ alkylamino, C₁-C₂₄ arylamino, C₁-C₂₄ heteroarylamino, C₁-C₂₄ alkylsilyl, C₁-C₂₄ arylsilyl, and C₁-C₂₄ aryloxy, or a combination thereof. The term "unsubstituted" in the same definition indicates having no substituent.

In the "substituted or unsubstituted C₁-C₁₀ alkyl", "substituted or unsubstituted C₆-C₃₀ aryl", etc., the number of carbon atoms in the alkyl or aryl group indicates the number of carbon atoms constituting the unsubstituted alkyl or aryl moiety without considering the number of carbon atoms in the substituent(s). For example, a phenyl group substituted with a butyl group at the paraposition corresponds to a C₆ aryl group substituted with a C₄ butyl group.

As used herein, the expression "form a ring with an adjacent substituent" means that the corresponding substituent combines with an adjacent substituent to form a substituted or unsubstituted alicyclic or aromatic ring and the term "adjacent substituent" may mean a substituent on an atom directly attached to an atom substituted with the corresponding substituent, a substituent disposed sterically closest to the corresponding substituent or another substituent on an atom substituted with the corresponding substituent. For example, two substituents substituted at the ortho position of a benzene ring or two substituents on the same carbon in an aliphatic ring may be considered "adjacent" to each other.

In the present invention, the alkyl groups may be straight or branched. The number of carbon atoms in the alkyl groups is not particularly limited but is preferably from 1 to 20. Specific examples of the alkyl groups include, but are not limited to, methyl, ethyl, propyl, n-propyl, isopropyl, butyl, n-butyl, isobutyl, tert-butyl, sec-butyl, 1-methylbutyl, 1-ethylbutyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethylpropyl, 1,1-dimethylpropyl, isohexyl, 2-methylpentyl, 4-methylhexyl, and 5-methylhexyl groups.

The alkenyl group is intended to include straight and branched ones and is optionally substituted with one or more other substituents. The alkenyl group may be specifically a vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, stilbenyl or styrenyl group but is not limited thereto.

The alkynyl group is intended to include straight and branched ones and is optionally substituted with one or more other substituents. The alkynyl group may be, for example, ethynyl or 2-propynyl but is not limited thereto.

The cycloalkyl group is intended to include monocyclic and polycyclic ones and is optionally substituted with one or more other substituents. As used herein, the term "polycyclic" means that the cycloalkyl group is directly attached or fused to one or more other cyclic groups. The other cyclic groups may be cycloalkyl groups and other examples thereof include heterocycloalkyl, aryl, and heteroaryl groups. The cycloalkyl group may be specifically a cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl or cyclooctyl group but is not limited thereto.

The heterocycloalkyl group is intended to include monocyclic and polycyclic ones interrupted by a heteroatom such as O, S, Se, N or Si and is optionally substituted with one or more other substituents. As used herein, the term "polycyclic" means that the heterocycloalkyl group is directly attached or fused to one or more other cyclic groups. The other cyclic groups may be heterocycloalkyl groups and other examples thereof include cycloalkyl, aryl, and heteroaryl groups.

The aryl groups may be monocyclic or polycyclic ones. Examples of the monocyclic aryl groups include, but are not limited to, phenyl, biphenyl, terphenyl, and stilbenyl groups. Examples of the polycyclic aryl groups include naphthyl, anthracenyl, phenanthrenyl, pyrenyl, perylenyl, tetracenyl, chrysenyl, fluorenyl, acenaphthacenyl, triphenylene, and fluoranthrene groups but the scope of the present invention is not limited thereto.

The heteroaryl groups refer to heterocyclic groups interrupted by one or more heteroatoms. Examples of the heteroaryl groups include, but are not limited to, thiophene, furan, pyrrole, imidazole, triazole, oxazole, oxadiazole, triazole, pyridyl, bipyridyl, pyrimidyl, triazine, triazole, acridyl, pyridazine, pyrazinyl, quinolinyl, quinazoline, quinoxalinyl, phthalazinyl, pyridopyrimidinyl, pyridopyrazinyl, pyrazinopyrazinyl, isoquinoline, indole, carbazole, benzoxazole, benzimidazole, benzothiazole, benzocarbazole, benzothiophene, dibenzothiophene, benzofuranyl, dibenzofuranyl, phenanthroline, thiazolyl, isoxazolyl, oxadiazolyl, thiadiazolyl, benzothiazolyl, and phenothiazinyl groups.

The alkoxy group may be specifically a methoxy, ethoxy, propoxy, isobutyloxy, sec-butyloxy, pentyloxy, iso-amyloxy or hexyloxy group but is not limited thereto.

The silyl group is intended to include alkyl-substituted silyl groups and aryl-substituted silyl groups. Specific examples of such silyl groups include trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl.

The amine groups may be, for example, -NH₂, alkylamine groups, and arylamine groups. The arylamine groups are aryl-substituted amine groups and the alkylamine groups are alkyl-substituted amine groups. Examples of the arylamine groups include substituted or unsubstituted monoarylamine groups, substituted or unsubstituted diarylamine groups, and substituted or unsubstituted triarylamine groups. The aryl groups in the arylamine groups may be monocyclic or polycyclic ones. The arylamine groups may include two or more aryl groups. In this case, the aryl groups may be monocyclic aryl groups or polycyclic aryl groups. Alternatively, the aryl groups may consist of a monocyclic aryl group and a polycyclic aryl group. The aryl groups in the arylamine groups may be selected from those exemplified above.

The aryl groups in the aryloxy group and the arylthioxy group are the same as those described above. Specific examples of the aryloxy groups include, but are not limited to, phenoxy, p-tolyloxy, m-tolyloxy, 3,5-dimethylphenoxy, 2,4,6-trimethylphenoxy, p-tert-butylphenoxy, 3-biphenyloxy, 4-biphenyloxy, 1-naphthyloxy, 2-naphthyloxy, 4-methyl-1-naphthyloxy, 5-methyl-2-naphthyloxy, 1-anthryloxy, 2-anthryloxy, 9-anthryloxy, 1-phenanthryloxy, 3-phenanthryloxy, and 9-phenanthryloxy groups. The arylthioxy group may be, for example, a phenylthioxy, 2-methylphenylthioxy or 4-tert-butylphenylthioxy group but is not limited thereto.

The halogen group may be, for example, fluorine, chlorine, bromine or iodine.

The polycyclic aromatic derivative represented by Formula A according to the present invention can be employed as a dopant compound in an organic layer, preferably a light emitting layer of an organic electroluminescent device. The polycyclic aromatic derivative may be selected from, but not limited to, the following compounds 1 to 141:

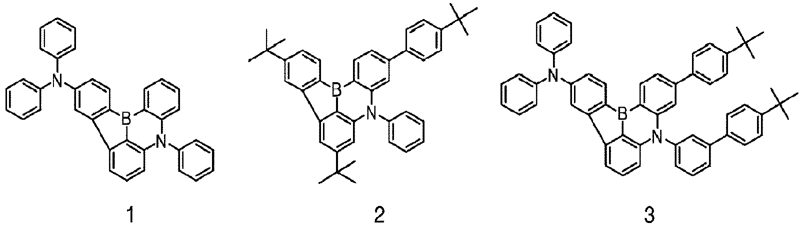

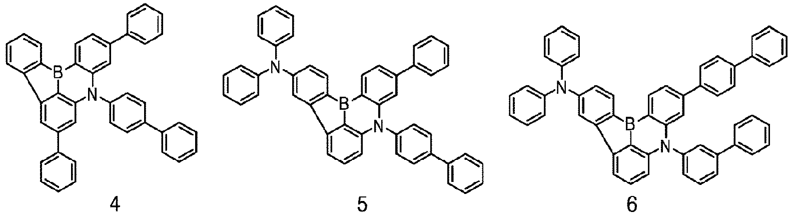

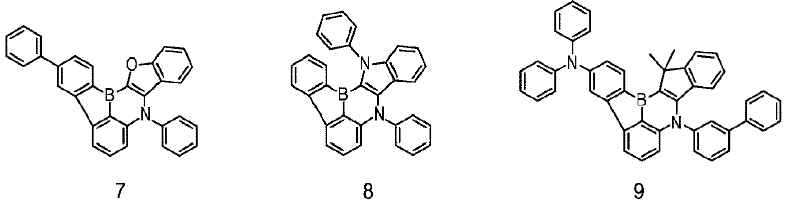

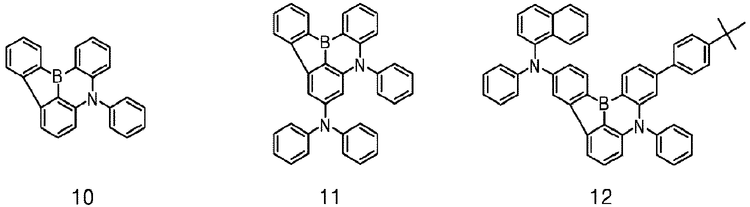

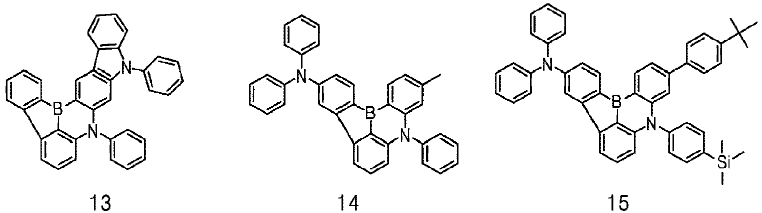

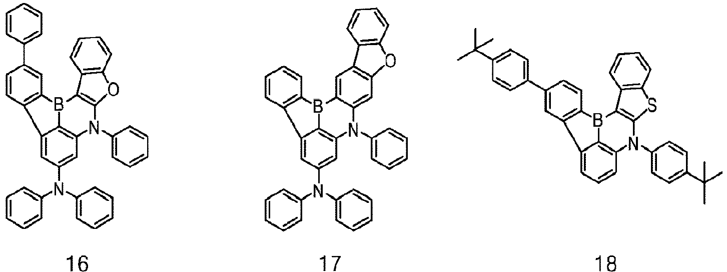

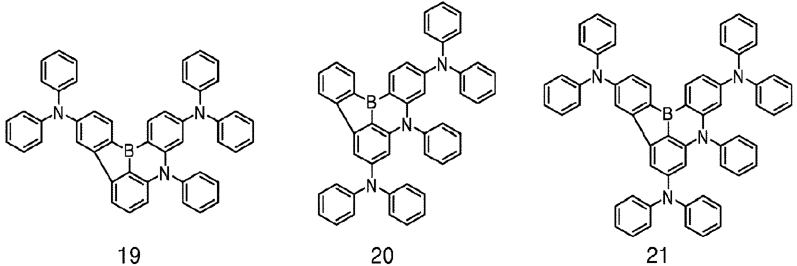

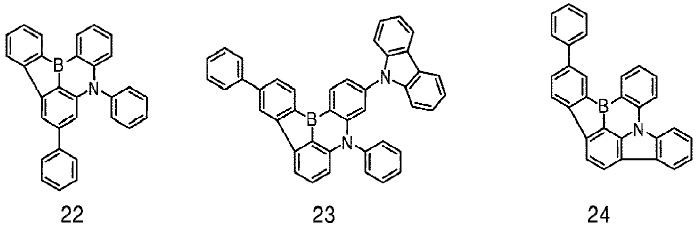

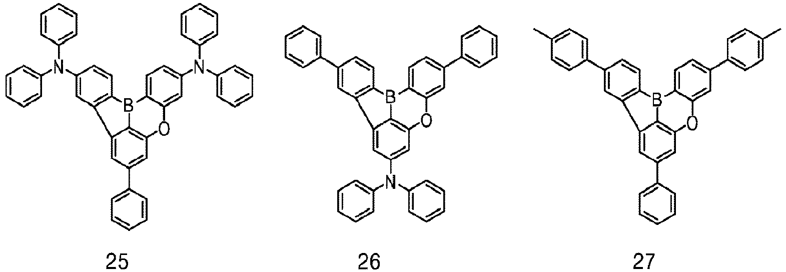

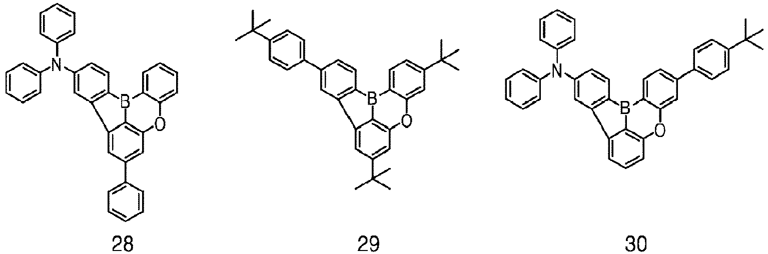

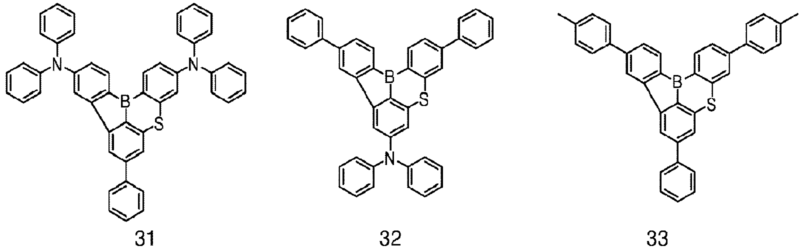

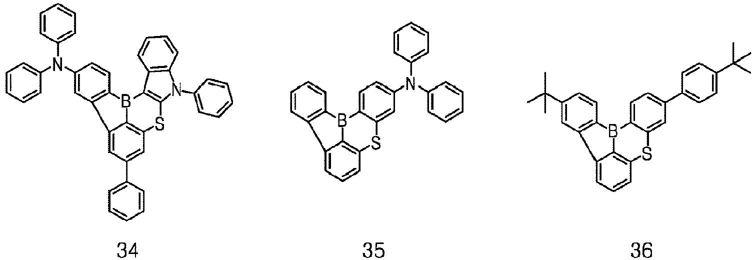

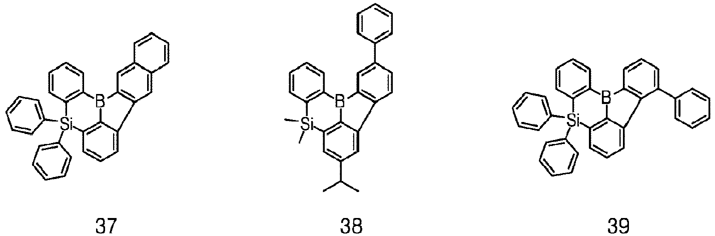

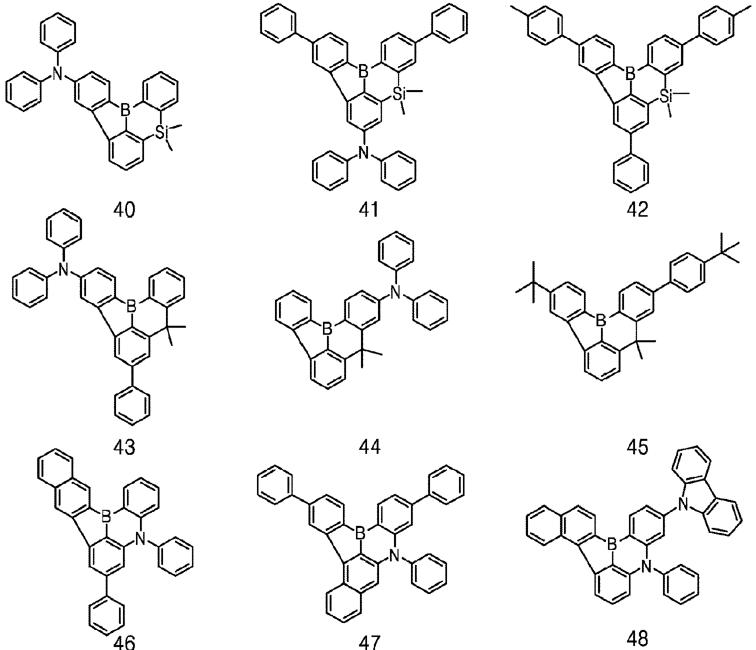

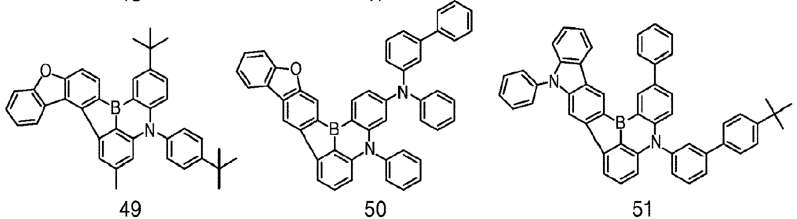

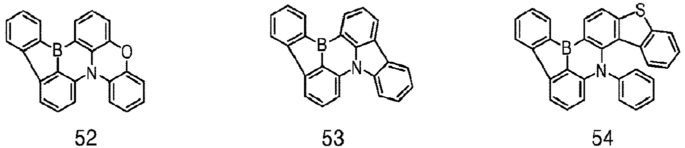

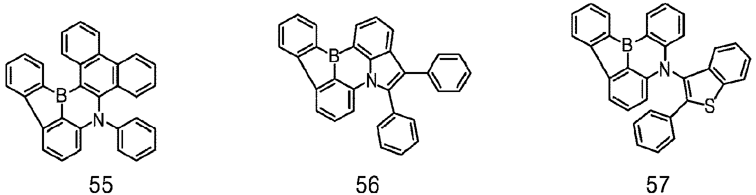

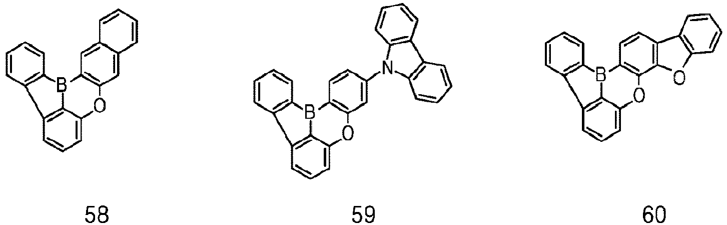

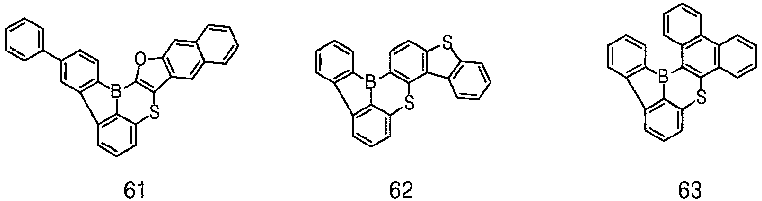

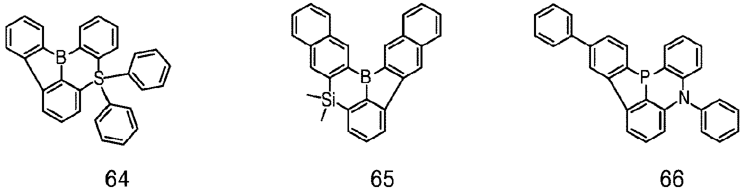

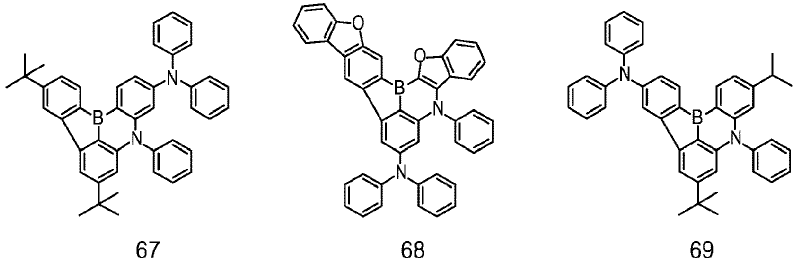

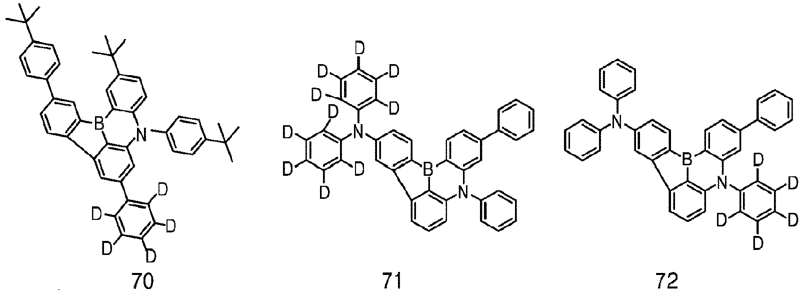

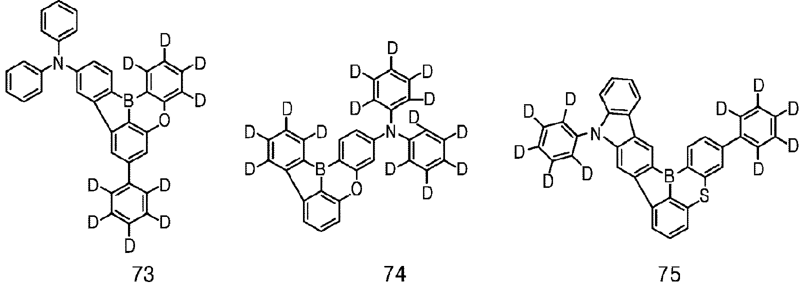

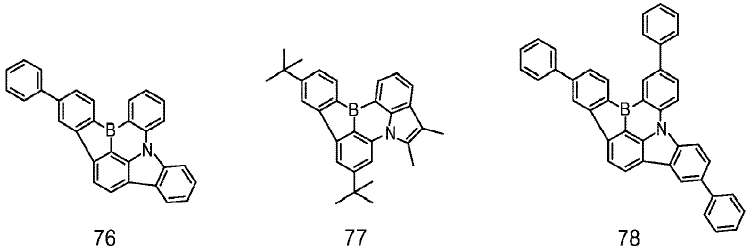

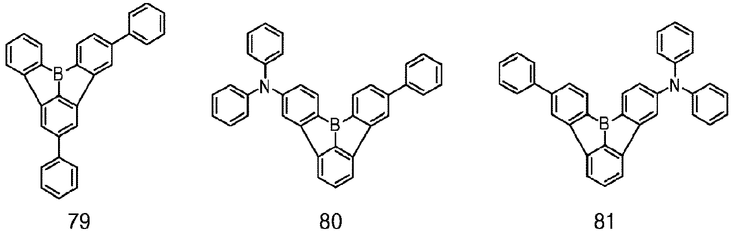

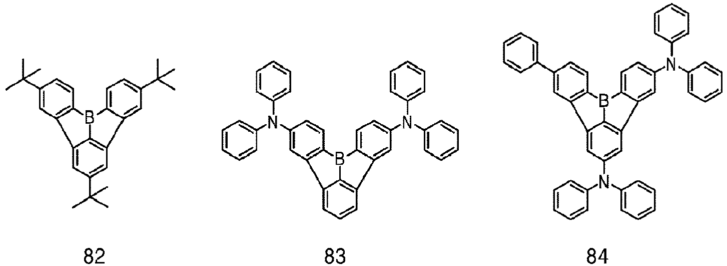

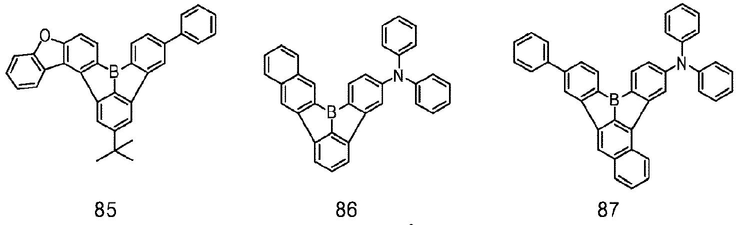

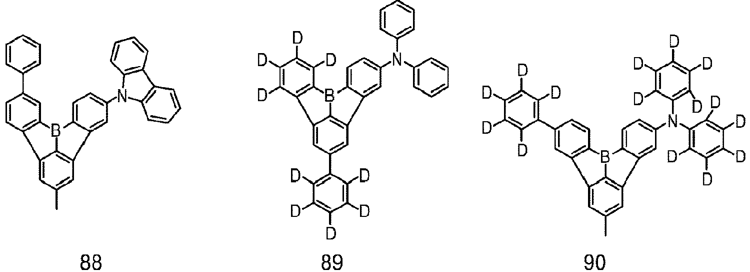

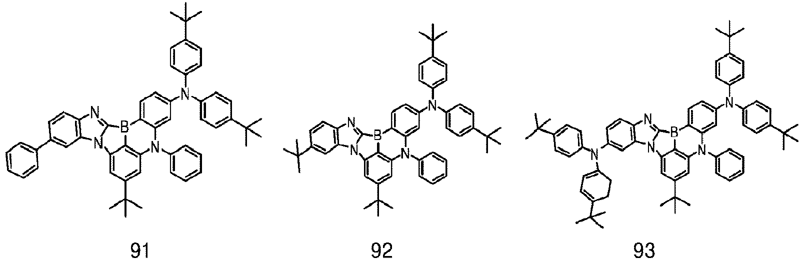

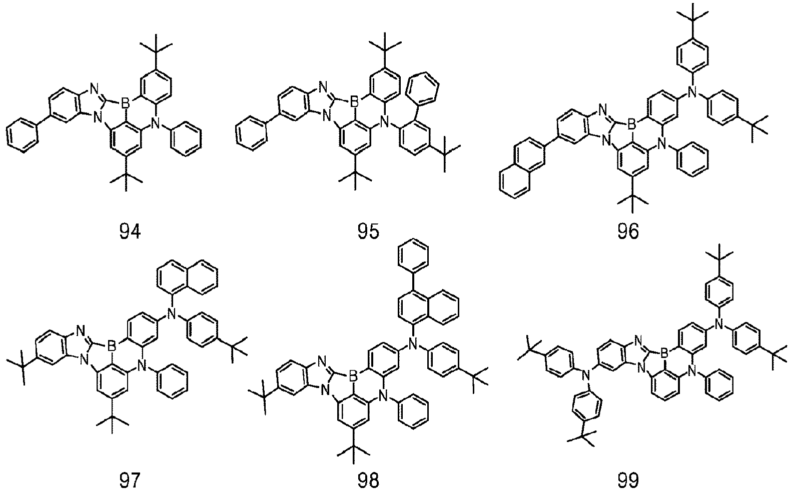

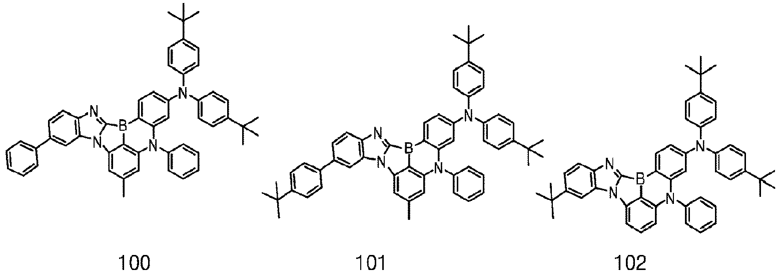

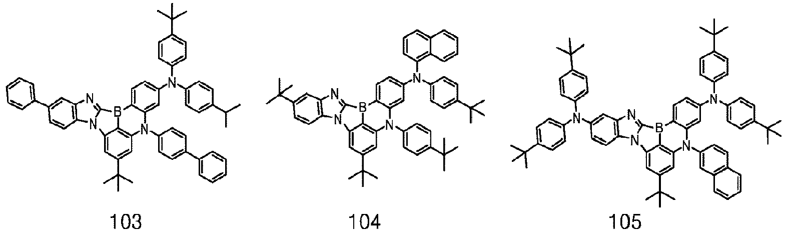

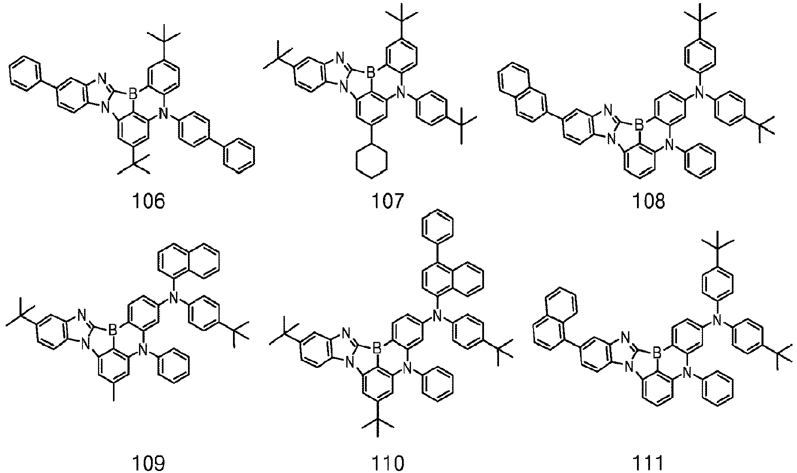

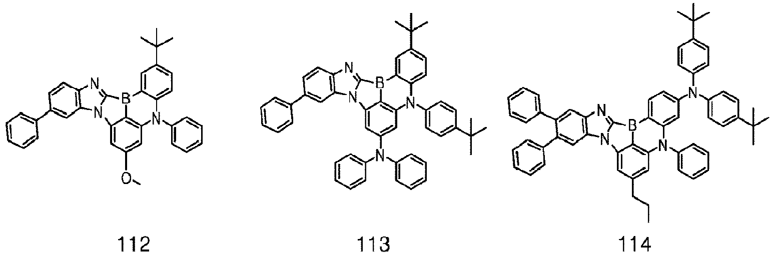

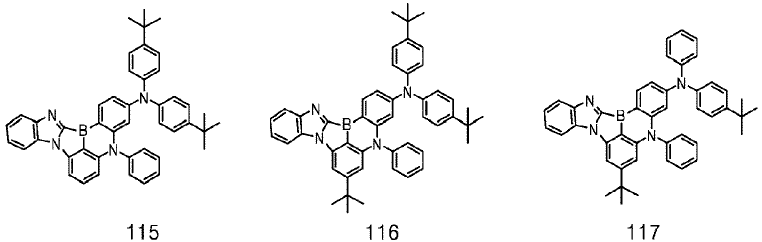

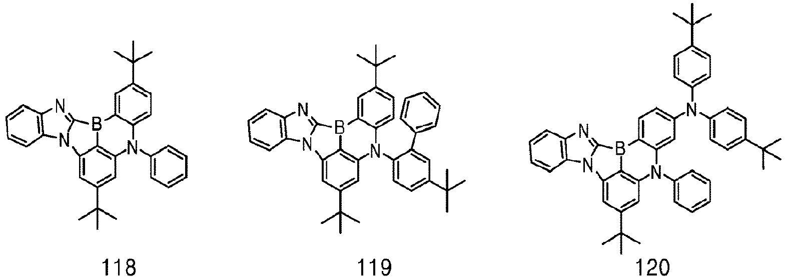

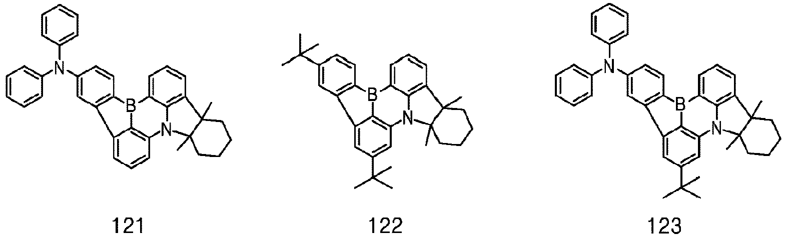

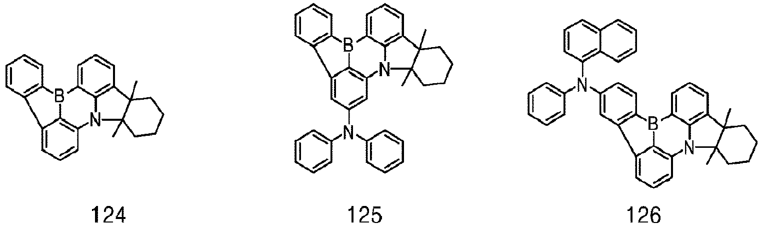

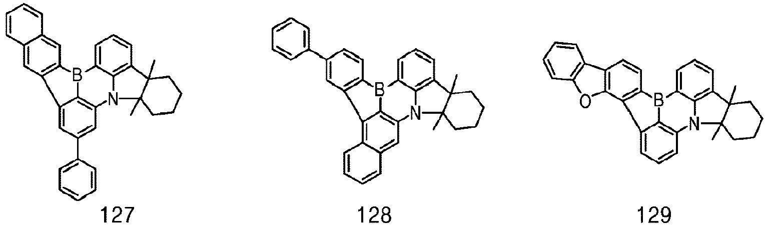

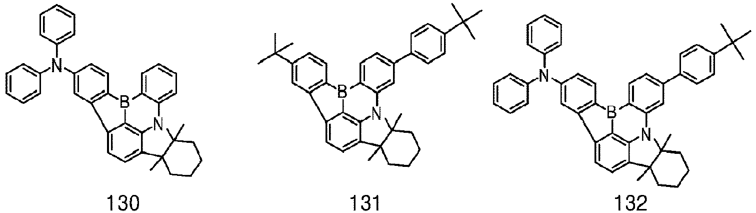

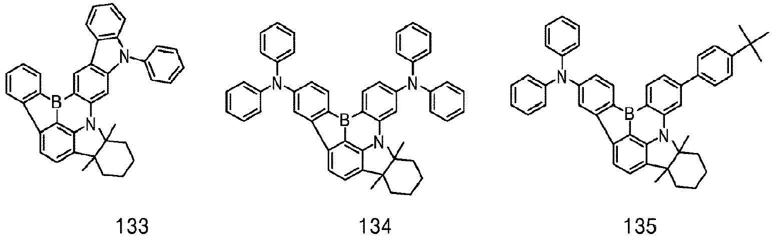

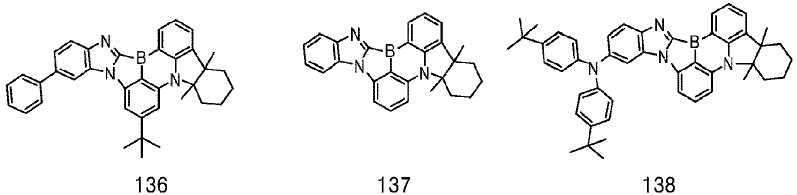

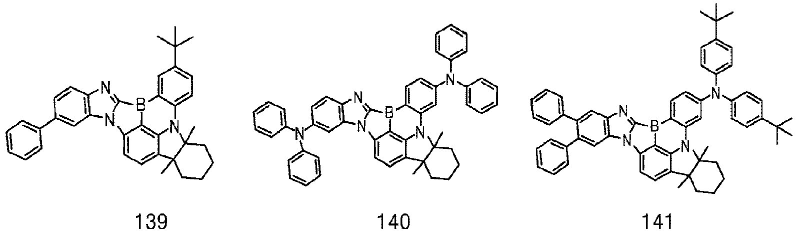

The present invention is also directed to an organic electroluminescent device including a first electrode, a second electrode, and one or more organic layers interposed between the first and second electrodes wherein one of the organic layers is a light emitting layer employing the compound represented by Formula A as a dopant.

The light emitting layer of the organic electroluminescent device employs a combination of the compound represented by Formula A as a dopant and an anthracene derivative represented by Formula H1: 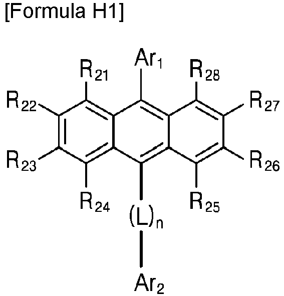 wherein R₂₁ to R₂₈ are identical to or different from each other and are each independently selected from the group consisting of hydrogen, deuterium, substituted or unsubstituted C₁-C₃₀ alkyl, substituted or unsubstituted C₂-C₃₀ alkenyl, substituted or unsubstituted C₃-C₃₀ cycloalkyl, substituted or unsubstituted C₅-C₃₀ cycloalkenyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₆-C₅₀ aryl, substituted or unsubstituted C₂-C₅₀ heteroaryl, substituted or unsubstituted silicon, substituted or unsubstituted boron, substituted or unsubstituted silane, carbonyl, phosphoryl, amino, nitrile, hydroxyl, nitro, halogen, amide, and ester, with the proviso that R₂₁ to R₂₈ are optionally bonded to each other to form a fused aliphatic, aromatic, heteroaliphatic or heteroaromatic ring or each of R₂₁ to R₂₈ is optionally linked to an adjacent substituent to form a fused aliphatic, aromatic, heteroaliphatic or heteroaromatic ring, Ar₁ and Ar₂ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₁-C₃₀ alkylsilyl, and substituted or unsubstituted C₆-C₃₀ arylsilyl, L is a single bond or is substituted or unsubstituted C₆-C₂₀ arylene or substituted or unsubstituted C₂-C₂₀ heteroarylene, and n is an integer from 0 to 3, or Formula H2: 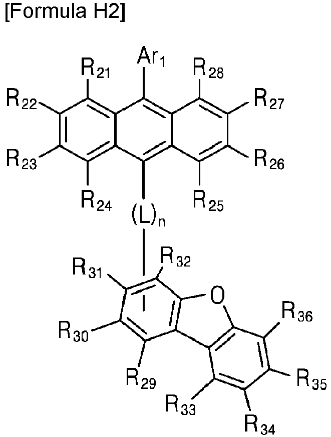 wherein R₂₁ to R₃₆ are identical to or different from each other and are each independently selected from the group consisting of hydrogen, deuterium, substituted or unsubstituted C₁-C₃₀ alkyl, substituted or unsubstituted C₂-C₃₀ alkenyl, substituted or unsubstituted C₃-C₃₀ cycloalkyl, substituted or unsubstituted C₅-C₃₀ cycloalkenyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₆-C₅₀ aryl, substituted or unsubstituted C₂-C₅₀ heteroaryl, substituted or unsubstituted silicon, substituted or unsubstituted boron, substituted or unsubstituted silane, carbonyl, phosphoryl, amino, nitrile, hydroxyl, nitro, halogen, amide, and ester, with the proviso that one of R₂₉ to R₃₂ is bonded to L and that R₂₁ to R₃₆ are optionally bonded to each other to form a fused aliphatic, aromatic, heteroaliphatic or heteroaromatic ring or each of R₂₁ to R₃₆ is optionally linked to an adjacent substituent to form a fused aliphatic, aromatic, heteroaliphatic or heteroaromatic ring, Ar₁ is selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₁-C₃₀ alkylsilyl, and substituted or unsubstituted C₆-C₃₀ arylsilyl, L is a single bond or is substituted or unsubstituted C₆-C₂₀ arylene or substituted or unsubstituted C₂-C₂₀ heteroarylene, and n is an integer from 0 to 3.

The anthracene derivative represented by Formula H1 or H2 is employed as a host in the light emitting layer.

According to one embodiment of the present invention, the anthracene derivative of Formula H1 may be selected from the following compounds H101 to H166:

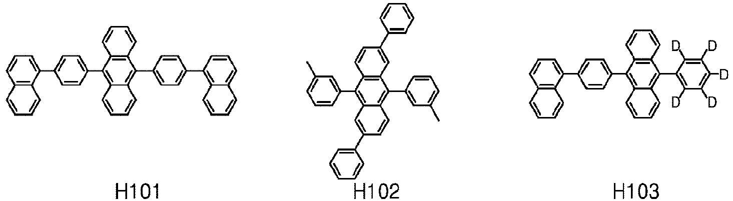

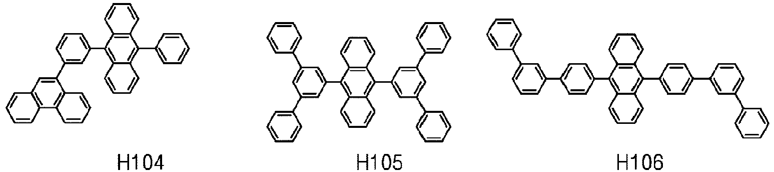

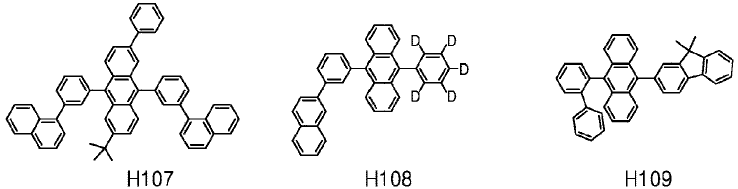

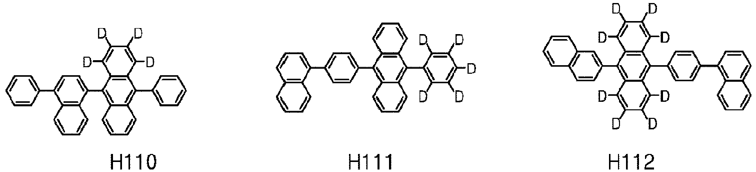

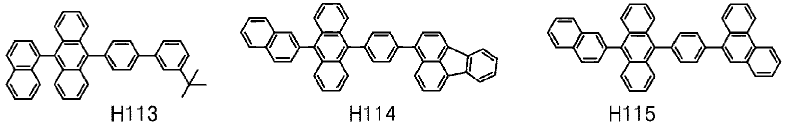

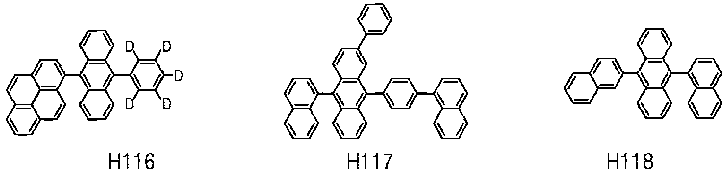

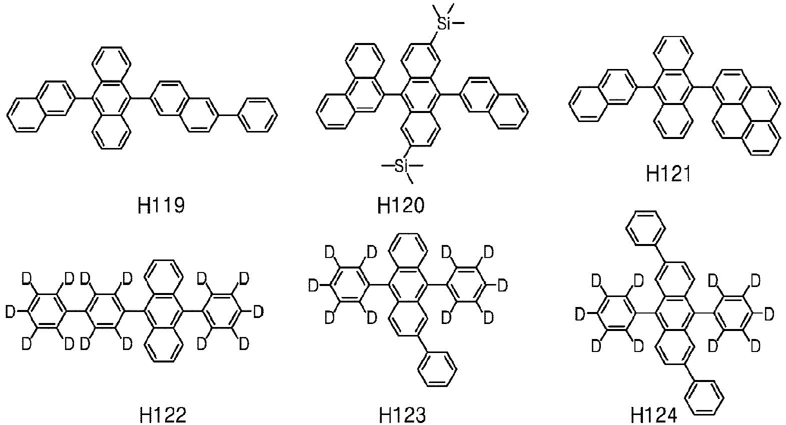

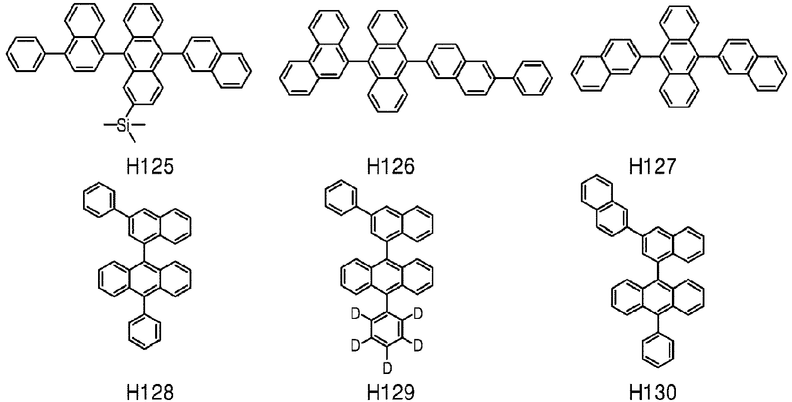

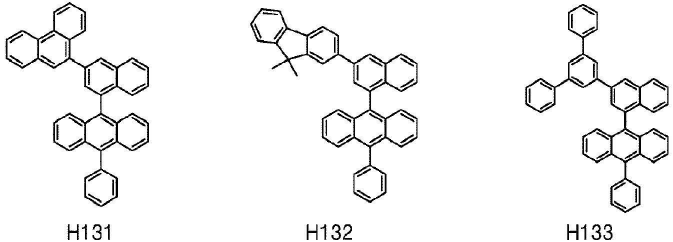

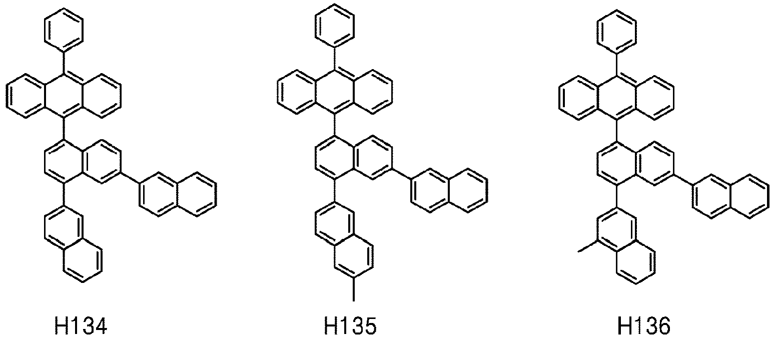

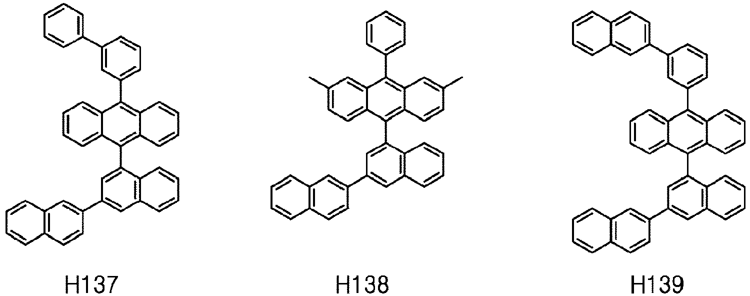

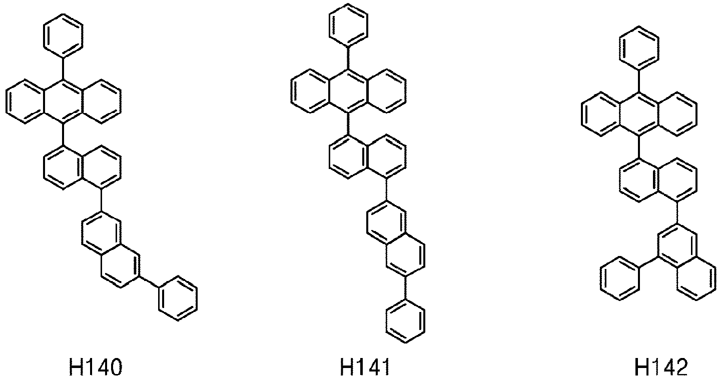

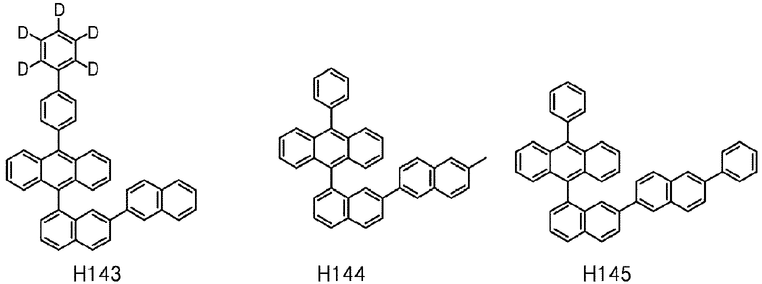

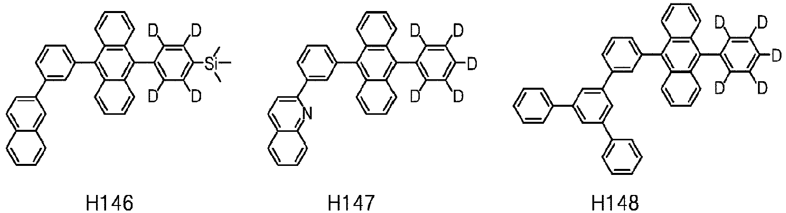

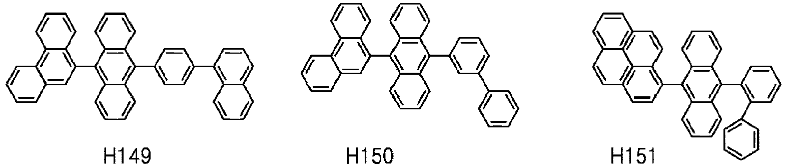

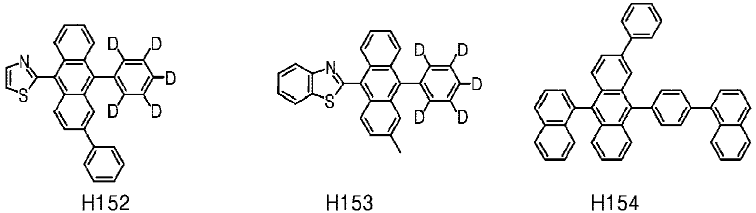

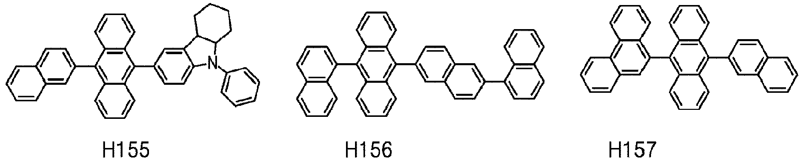

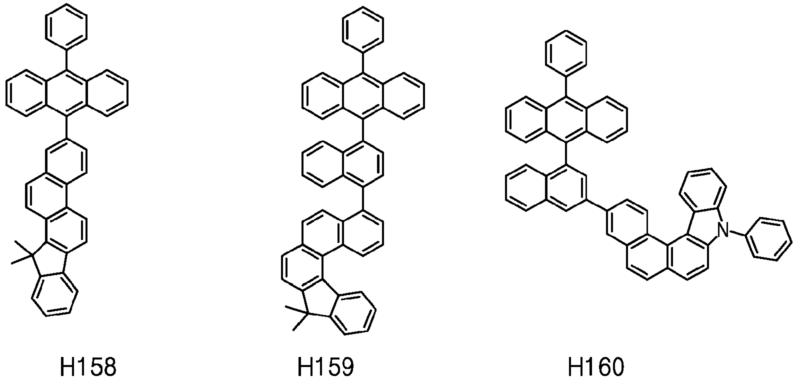

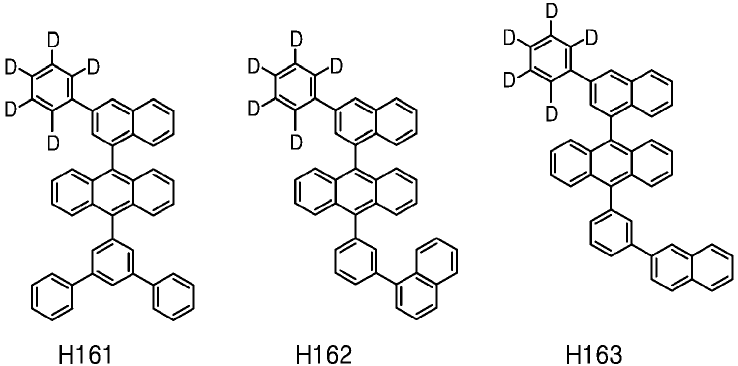

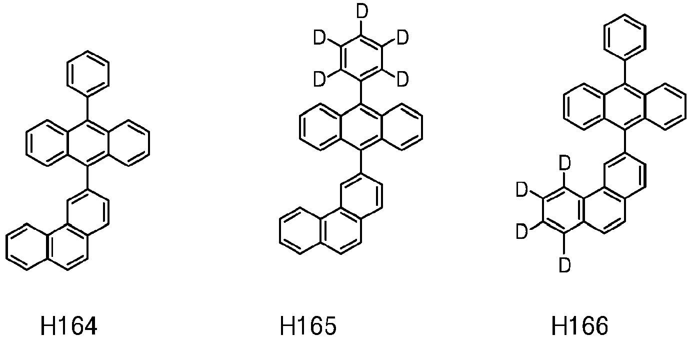

According to one embodiment of the present invention, the anthracene derivative of Formula H2 may be selected from the following compounds H201 to H281:

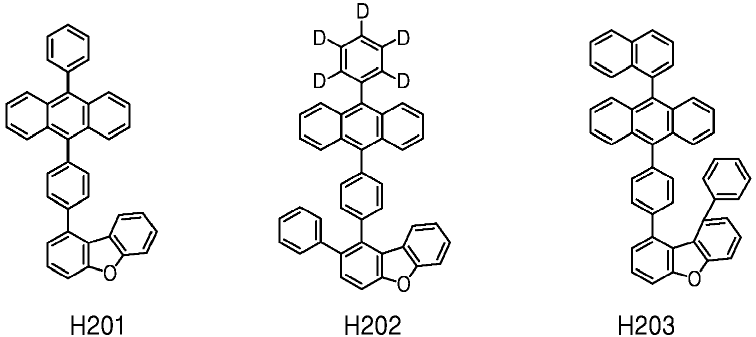

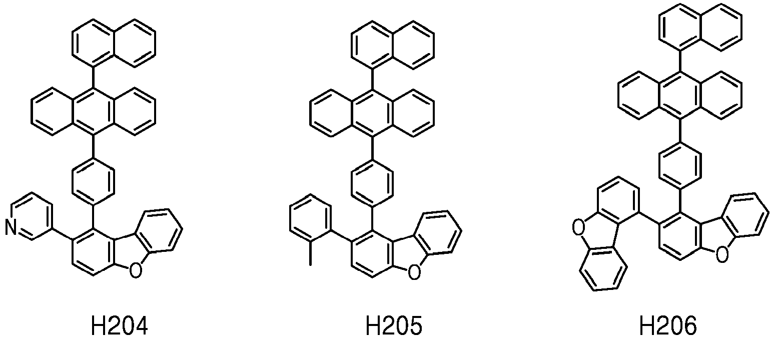

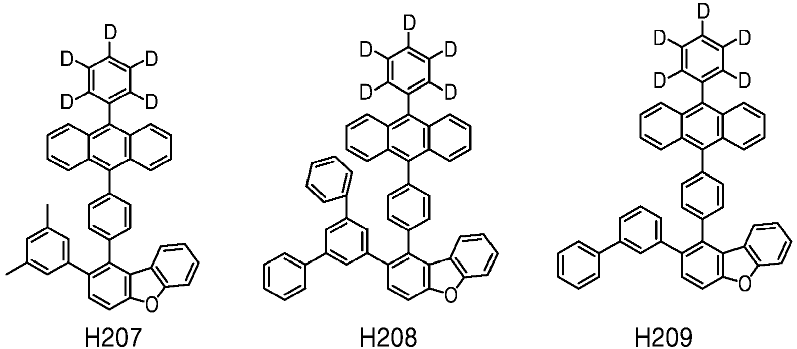

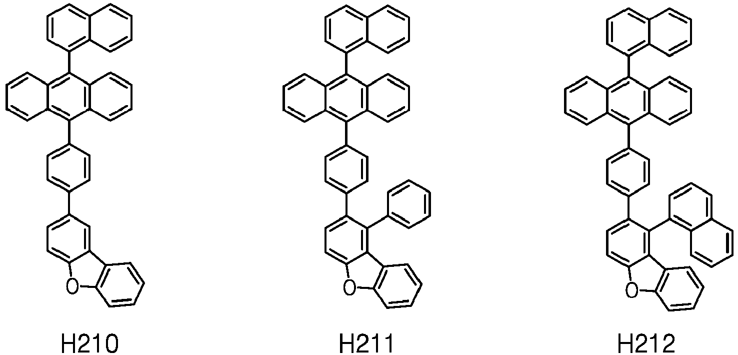

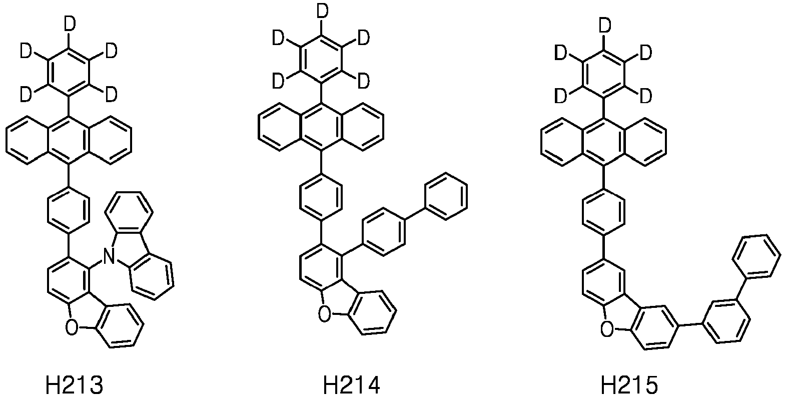

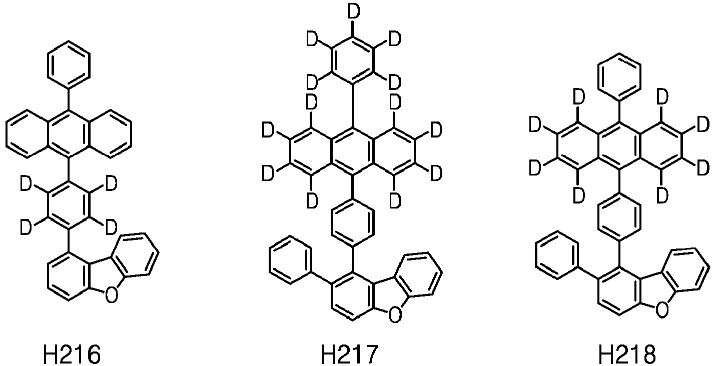

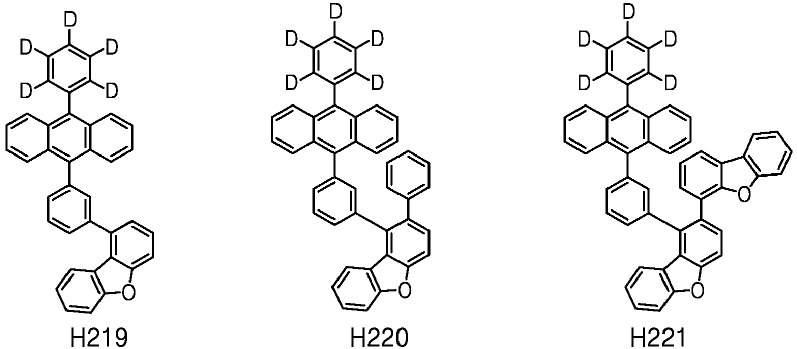

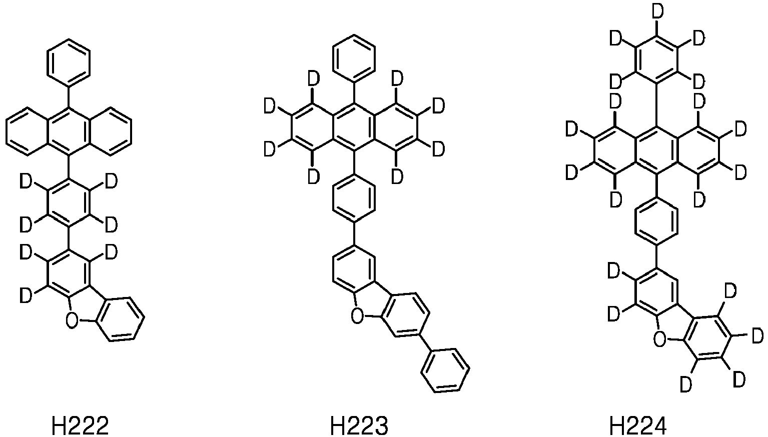

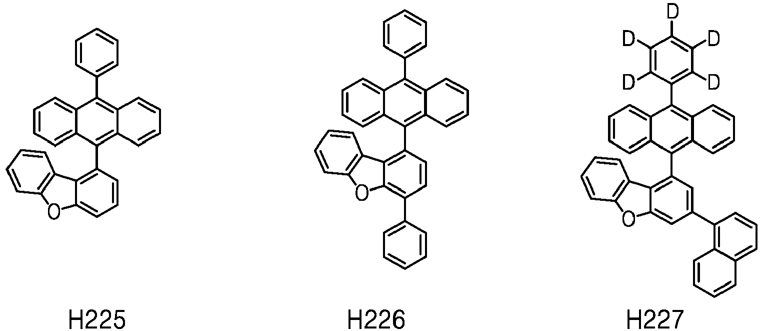

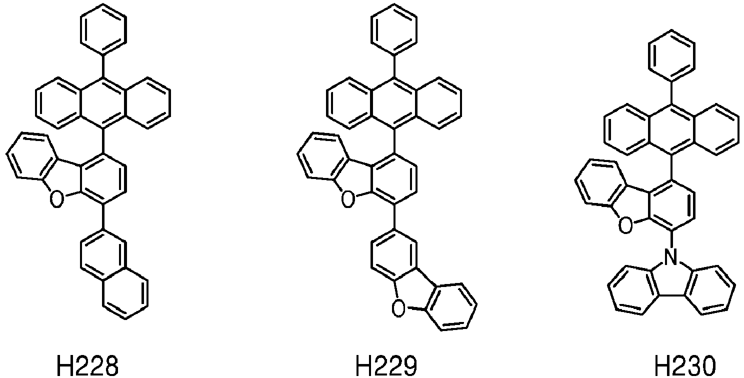

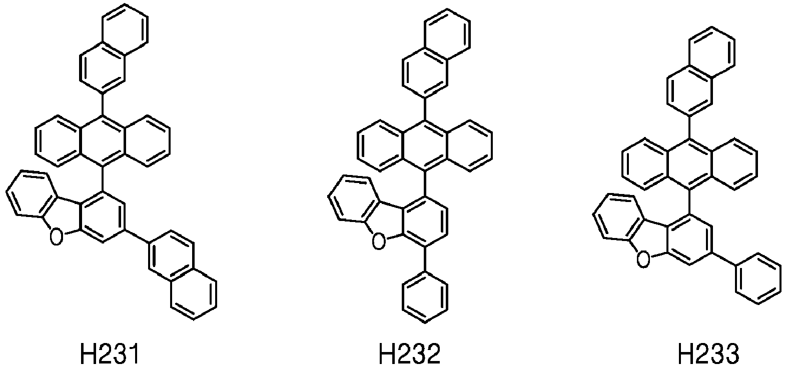

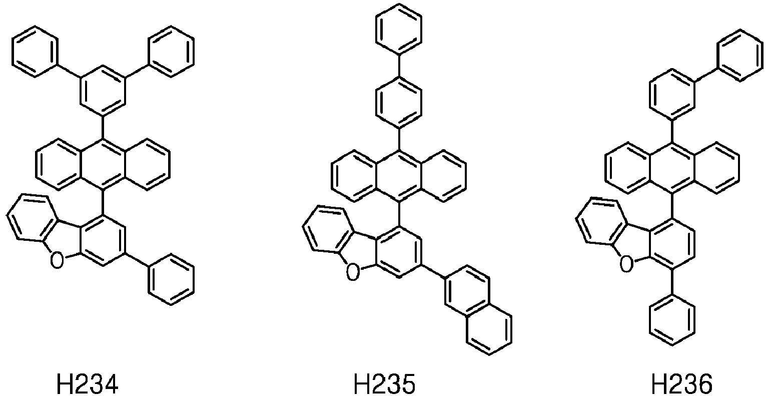

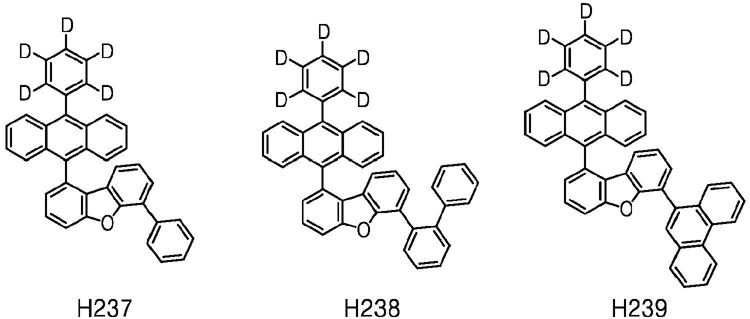

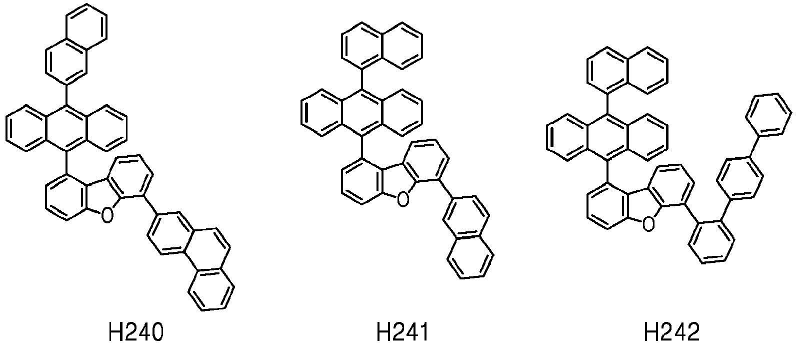

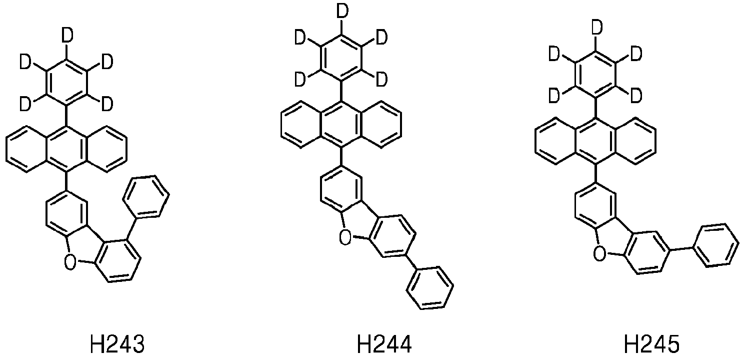

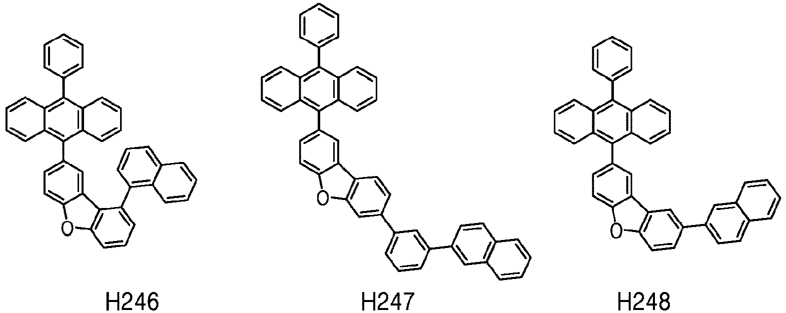

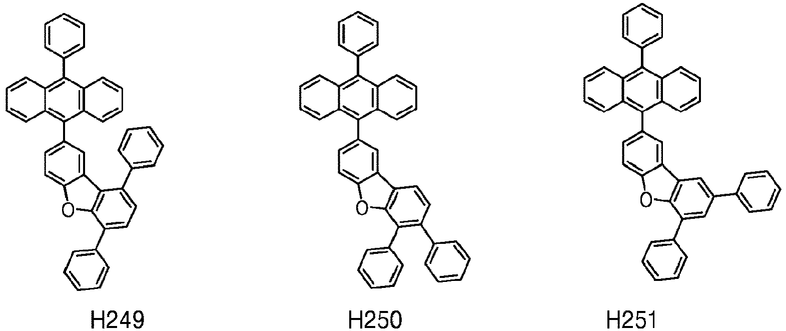

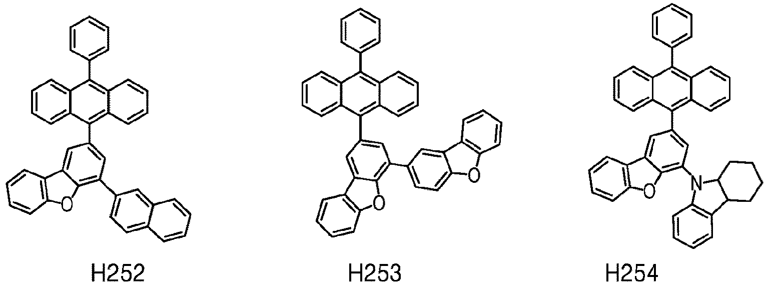

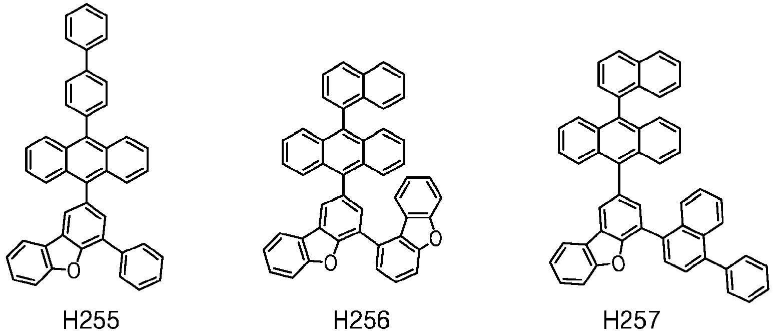

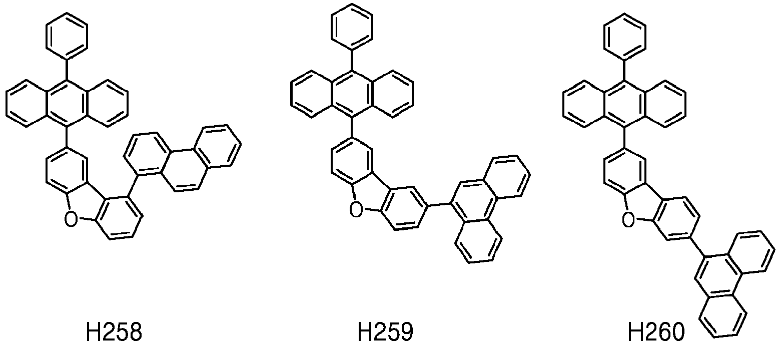

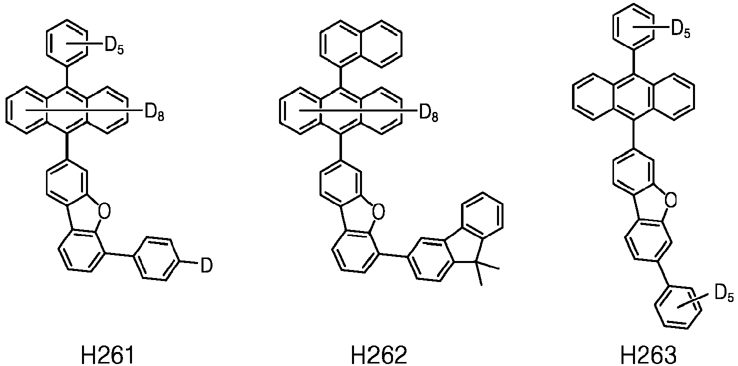

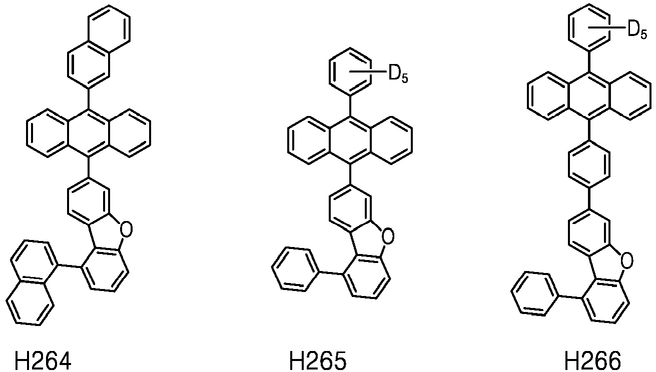

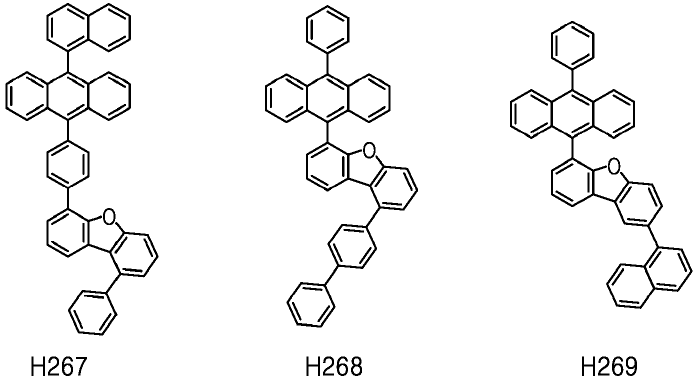

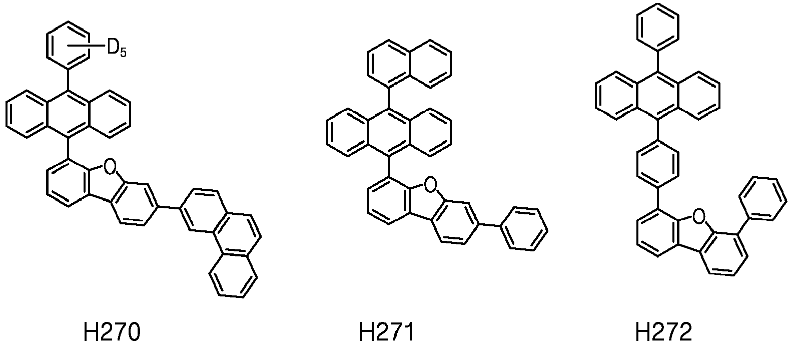

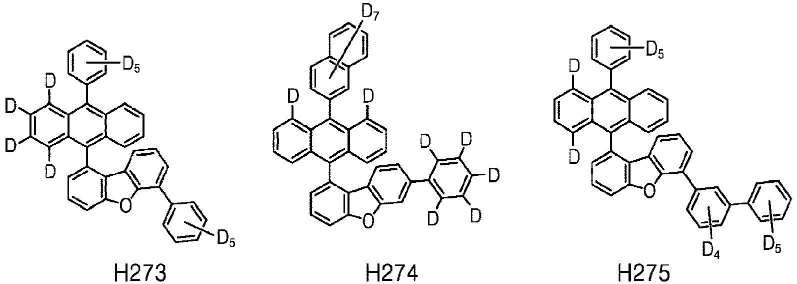

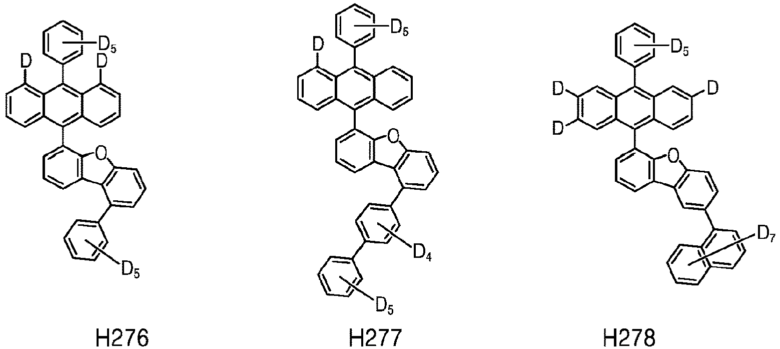

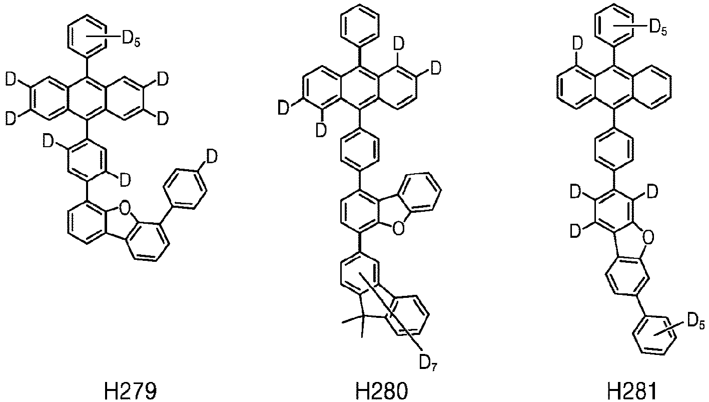

The organic layers of the organic electroluminescent device according to the present invention may form a monolayer structure. Alternatively, the organic layers may have a multilayer stack structure. For example, the organic layers may have a structure including a hole injecting layer, a hole transport layer, a hole blocking layer, a light emitting layer, an electron blocking layer, an electron transport layer, and an electron injecting layer but is not limited to this structure. The number of the organic layers is not limited and may be increased or decreased. Preferred structures of the organic layers of the organic electroluminescent device according to the present invention will be explained in more detail in the Examples section that follows.

According to one embodiment of the present invention, the organic electroluminescent device includes a substrate, a first electrode (anode), one or more organic layers, a second electrode (cathode), and a capping layer formed under the first electrode (bottom emission type) or on the second electrode (top emission type).

When the organic electroluminescent device is of a top emission type, light from the light emitting layer is emitted to the cathode and passes through the capping layer (CPL) formed using the compound of the present invention having a relatively high refractive index. The wavelength of the light is amplified in the capping layer, resulting in an increase in luminous efficiency. Also when the organic electroluminescent device is of a bottom emission type, the compound of the present invention can be employed in the capping layer to improve the luminous efficiency of the organic electroluminescent device based on the same principle.

A more detailed description will be given concerning exemplary embodiments of the organic electroluminescent device according to the present invention.

The organic electroluminescent device according to an embodiment of the present invention includes an anode, a hole transport layer, a light emitting layer, an electron transport layer, and a cathode. The organic electroluminescent device may optionally further include a hole injecting layer between the anode and the hole transport layer and an electron injecting layer between the electron transport layer and the cathode. If necessary, the organic electroluminescent device may further include one or two intermediate layers such as a hole blocking layer or an electron blocking layer. The organic electroluminescent device may further include one or more organic layers such as a capping layer that have various functions depending on the desired characteristics of the device.

A specific structure of the organic electroluminescent device according to one embodiment of the present invention, a method for fabricating the device, and materials for the organic layers are as follows.

First, an anode material is coated on a substrate to form an anode. The substrate may be any of those used in general electroluminescent devices. The substrate is preferably an organic substrate or a transparent plastic substrate that is excellent in transparency, surface smoothness, ease of handling, and waterproofness. A highly transparent and conductive metal oxide such as indium tin oxide (ITO), indium zinc oxide (IZO), tin oxide (SnO₂) or zinc oxide (ZnO) is used as the anode material.

A hole injecting material is coated on the anode by vacuum thermal evaporation or spin coating to form a hole injecting layer. Then, a hole transport material is coated on the hole injecting layer by vacuum thermal evaporation or spin coating to form a hole transport layer.

The hole injecting material is not specially limited so long as it is usually used in the art. Specific examples of such materials include 4,4',4"-tris(2-naphthylphenyl-phenylamino)triphenylamine (2-TNATA), N,N'-di(1-naphthyl)-N,N'-diphenylbenzidine (NPD), N,N'-diphenyl-N,N'-bis(3-methylphenyl)-1,1'-biphenyl-4,4'-diamine (TPD), and N,N'-diphenyl-N,N'-bis(4-(phenyl-m-tolylamino)phenyl)biphenyl-4,4'-diamine (DNTPD).

The hole transport material is not specially limited so long as it is commonly used in the art. Examples of such materials include N,N'-bis(3-methylphenyl)-N,N'-diphenyl-(1,1-biphenyl)-4,4'-diamine (TPD) and N,N'-di(naphthalen-1-yl)-N,N'-diphenylbenzidine (a-NPD).

Subsequently, a hole auxiliary layer and a light emitting layer are sequentially laminated on the hole transport layer. A hole blocking layer may be optionally formed on the light emitting layer by vacuum thermal evaporation or spin coating. The hole blocking layer is formed as a thin film and blocks holes from entering a cathode through the organic light emitting layer. This role of the hole blocking layer prevents the lifetime and efficiency of the device from deteriorating. A material having a very low highest occupied molecular orbital (HOMO) energy level is used for the hole blocking layer. The hole blocking material is not particularly limited so long as it can transport electrons and has a higher ionization potential than the light emitting compound. Representative examples of suitable hole blocking materials include BAIq, BCP, and TPBI.

Examples of materials for the hole blocking layer include, but are not limited to, BAIq, BCP, Bphen, TPBI, NTAZ, BeBq₂, OXD-7, and Liq.

An electron transport layer is deposited on the hole blocking layer by vacuum thermal evaporation or spin coating, and an electron injecting layer is formed thereon. A cathode metal is deposited on the electron injecting layer by vacuum thermal evaporation to form a cathode, completing the fabrication of the organic electroluminescent device.

For example, lithium (Li), magnesium (Mg), aluminum (Al), aluminum-lithium (Al-Li), calcium (Ca), magnesium-indium (Mg-In) or magnesium-silver (Mg-Ag) may be used as the metal for the formation of the cathode. The organic electroluminescent device may be of top emission type. In this case, a transmissive material such as ITO or IZO may be used to form the cathode.

A material for the electron transport layer functions to stably transport electrons injected from the cathode. The electron transport material may be any of those known in the art and examples thereof include, but are not limited to, quinoline derivatives, particularly tris(8-quinolinolate)aluminum (Alq3), TAZ, BAIq, beryllium bis(benzoquinolin-10-olate (Bebq2), and oxadiazole derivatives such as PBD, BMD, and BND.

The light emitting layer of the organic electroluminescent device according to the present invention may further include various host materials and various dopant materials in addition to the dopant compound represented by Formula A.

Each of the organic layers can be formed by a monomolecular deposition or solution process. According to the monomolecular deposition process, the material for each layer is evaporated into a thin film under heat and vacuum or reduced pressure. According to the solution process, the material for each layer is mixed with a suitable solvent, and then the mixture is formed into a thin film by a suitable method, such as ink-jet printing, roll-to-roll coating, screen printing, spray coating, dip coating or spin coating.

The organic electroluminescent device of the present invention can be used in a display or lighting system selected from flat panel displays, flexible displays, monochromatic flat panel lighting systems, white flat panel lighting systems, flexible monochromatic lighting systems, and flexible white lighting systems.

### Mode for Carrying out the Invention

The present invention will be explained more specifically with reference to the following examples. However, it will be obvious to those skilled in the art that these examples are in no way intended to limit the scope of the invention.

### Synthesis Example 1: Synthesis of Compound 1

### Synthesis Example 1-(1): Synthesis of Intermediate 1-a

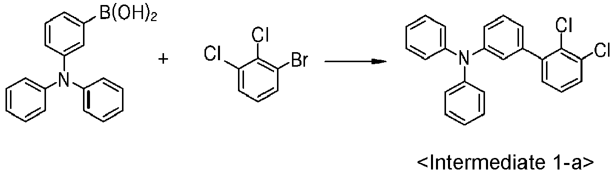

22.6 g (100 mmol) of 1-bromo-2,3-dichlorobenzene, 28.9 g (100 mmol) of 3-(diphenylamino)phenylboronic acid, 4 g (3 mmol) of tetrakis(triphenylphosphine)palladium, 41.5 g (300 mmol) of potassium carbonate, 250 mL of tetrahydrofuran, and 90 mL of distilled water were placed in a reactor. The mixture was stirred under reflux for 24 h. After completion of the reaction, the organic layer was concentrated under reduced pressure and purified by column chromatography to afford 30.4 g of Intermediate 1-a (yield 78%).

### Synthesis Example 1-(2): Synthesis of Intermediate 1-b

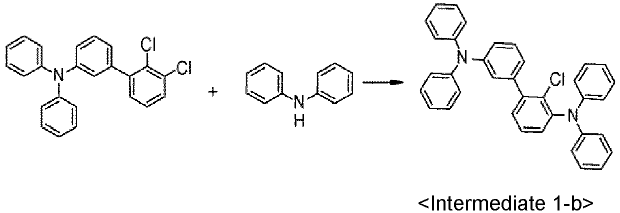

32.4 g (83 mmol) of Intermediate 1-a, 15.6 g (92 mmol) of diphenylamine, 1.6 g (2 mmol) of tris(dibenzylideneacetone)palladium, 16 g (166 mmol) of sodium tert-butoxide, 0.7 g (3 mmol) of tri-tert-butylphosphine, and 300 ml of toluene were placed in a reactor. The mixture was stirred under reflux for 24 h. After completion of the reaction, the reaction mixture was filtered. The filtrate was concentrated and purified by column chromatography to afford 30.4 g of Intermediate 1-b (yield 70%).

### Synthesis Example 1-3: Synthesis of Compound 1

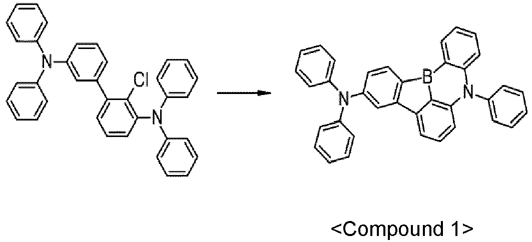

19.3 g (37 mmol) of Intermediate 1-b and 150 mL of tert-butylbenzene were placed in a reactor and 42.4 mL (74 mmol) of tert-butyllithium was added dropwise thereto at -78 °C. The mixture was stirred at 60 °C for 3 h. Nitrogen was blown into the mixture at the same temperature to remove heptane. After cooling to -78 °C, 7.1 mL (74 mmol) of boron tribromide was added dropwise. The resulting mixture was stirred at room temperature for 1 h. After dropwise addition of 9.6 g (74 mmol) of N,N-diisopropylethylamine at 0 °C, stirring was continued at 120 °C for 2 h.

An aqueous sodium acetate solution was added at room temperature, followed by stirring. After completion of the reaction, the reaction mixture was filtered. The filtrate was concentrated and purified by column chromatography to give 4.6 g of Compound 1 (yield 25%).

MS (MALDI-TOF): m/z 496.21 [M⁺]

### Synthesis Example 2: Synthesis of Compound 2

### Synthesis Example 2-(1): Synthesis of Intermediate 2-a

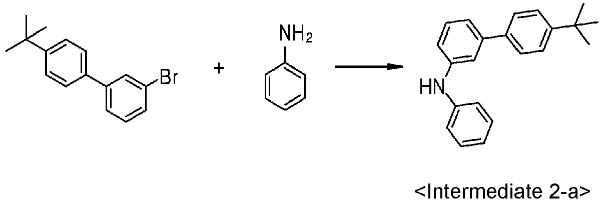

4.6 g (16 mmol) of 3-bromo-4'-(tert-butyl)biphenyl, 1.5 g (16 mmol) of aniline, 0.1 g (1 mmol) of palladium acetate, 3 g (32 mmol) of sodium tert-butoxide, 0.2 g (1 mmol) of bis(diphenylphosphino)-1,1'-binaphthyl, and 50 mL of toluene were placed in a reactor. The mixture was stirred under reflux for 24 h. After completion of the reaction, the reaction mixture was filtered. The filtrate was concentrated and purified by column chromatography to afford 3.8 g of Intermediate 2-a (yield 80%).

### Synthesis Example 2-(2): Synthesis of Compound 2

Compound 2 (yield 27%) was synthesized in the same manner as in Synthesis Examples 1-(1) to 1-(3), except that 1,3-dibromo-5-tert-butyl-2-chlorobenzene and 3-tert-butylphenylboronic acid were used instead of 1-bromo-2,3-dichlorobenzene and 3-(diphenylamino)phenylboronic acid, respectively, in Synthesis Example 1-(1) and Intermediate 2-a was used instead of diphenylamine in Synthesis Example 1-(2).

MS (MALDI-TOF): m/z 573.36 [M⁺]

### Synthesis Example 3: Synthesis of Compound 7

### Synthesis Example 3-(1): Synthesis of Intermediate 3-a

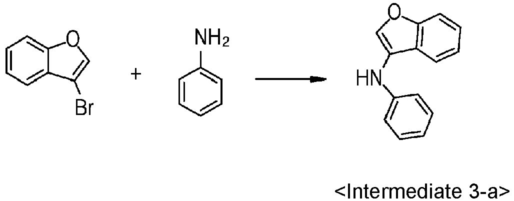

Intermediate 3-a (yield 77%) was synthesized in the same manner as in Synthesis Example 2-(1), except that 3-bromobenzofuran was used instead of 3-bromo-4'-(tert-butyl)biphenyl.

### Synthesis Example 3-(2): Synthesis of Compound 7

Compound 7 (yield 22%) was synthesized in the same manner as in Synthesis Examples 1-(1) to 1-(3), except that 3-biphenylboronic acid was used instead of 3-(diphenylamino)phenylboronic acid in Synthesis Example 1-(1) and Intermediate 3-a was used instead of diphenylamine in Synthesis Example 1-(2).

MS (MALDI-TOF): m/z 445.16 [M⁺]

### Synthesis Example 4: Synthesis of Compound 19

### Synthesis Example 4-(1): Synthesis of Intermediate 4-a

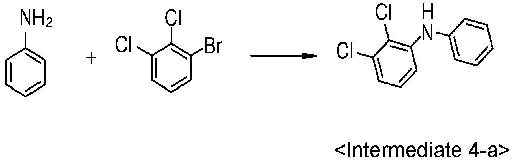

Intermediate 4-a (yield 71%) was synthesized in the same manner as in Synthesis Example 2-(1), except that 1-bromo-2,3-dichlorobenzene was used instead of 3-bromo-4'-(tert-butyl)biphenyl.

### Synthesis Example 4-(2): Synthesis of Intermediate 4-b

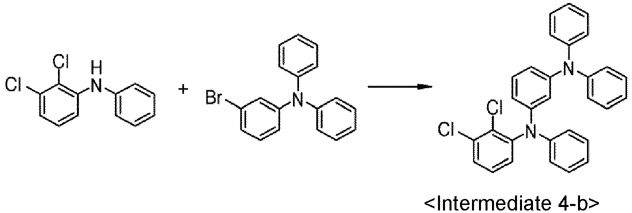

Intermediate 4-b (yield 78%) was synthesized in the same manner as in Synthesis Example 1-(2), except that 3-bromotriphenylamine and Intermediate 4-a were used instead of Intermediate 1-a and diphenylamine, respectively.

### Synthesis Example 4-(3): Synthesis of Intermediate 4-c

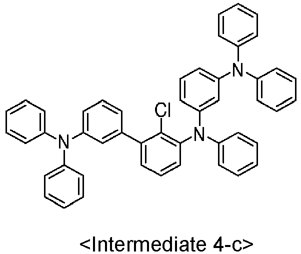

Intermediate 4-c (yield 64%) was synthesized in the same manner as in Synthesis Example 1-(1), except that Intermediate 4-b was used instead of 1-bromo-2,3-dichlorobenzene.

### Synthesis Example 4-(4): Synthesis of Compound 19

Compound 19 (yield 24%) was synthesized in the same manner as in Synthesis Example 1-(3), except that Intermediate 4-c was used instead of Intermediate 1-b.

MS (MALDI-TOF): m/z 663.28 [M⁺]

### Synthesis Example 5: Synthesis of Compound 24

### Synthesis Example 5-(1): Synthesis of Intermediate 5-a

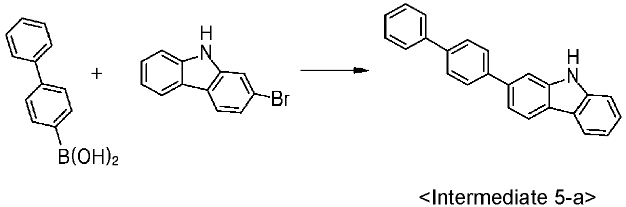

Intermediate 5-a (yield 64%) was synthesized in the same manner as in Synthesis Example 1-(1), except that 2-bromocarbazole and 4-biphenylboronic acid were used instead of 1-bromo-2,3-dichlorobenzene and 3-(diphenylamino)phenylboronic acid, respectively.

### Synthesis Example 5-(2): Synthesis of Intermediate 5-b

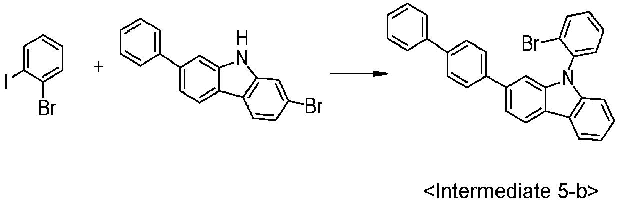

Intermediate 5-b (yield 68%) was synthesized in the same manner as in Synthesis Example 1-(2), except that 1-bromo-2-iodobenzene and Intermediate 5-a were used instead of Intermediate 1-a and diphenylamine, respectively.

### Synthesis Example 5-(3): Synthesis of Compound 24

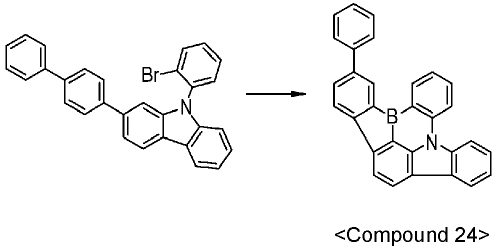

Compound 24 (yield 24%) was synthesized in the same manner as in Synthesis Example 1-(3), except that Intermediate 5-b was used instead of Intermediate 1-b.

MS (MALDI-TOF): m/z 403.15 [M⁺]

### Synthesis Example 6: Synthesis of Compound 30

### Synthesis Example 6-(1): Synthesis of Intermediate 6-a

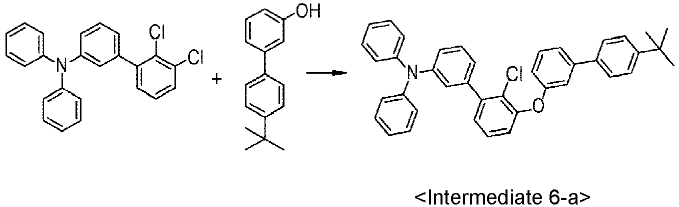

58.5 g (150 mmol) of Intermediate 1-a, 36.2 g (160 mmol) of 3-(4-tert-butylphenyl)phenol, 45.7 g (300 mmol) of potassium carbonate, and 250 mL of NMP were placed in a reactor. The mixture was stirred under reflux at 160 °C for 12 h. After completion of the reaction, the temperature was lowered to room temperature. NMP was distilled off under reduced pressure, followed by extraction. The extract was concentrated under reduced pressure and purified by column chromatography to afford 52.2 g of Intermediate 6-a (yield 60%).

### Synthesis Example 6-(2): Synthesis of Compound 30

Compound 30 (yield 22%) was synthesized in the same manner as in Synthesis Example 1-(3), except that Intermediate 6-a was used instead of Intermediate 1-b.

MS (MALDI-TOF): m/z 553.26 [M⁺]

### Synthesis Example 7: Synthesis of Compound 40

### Synthesis Example 7-(1): Synthesis of Intermediate 7-a

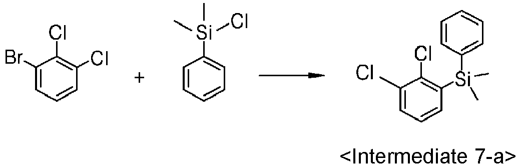

49.9 g (221 mmol) of 1-bromo-2,3-dichlorobenzene and 500 mL of tetrahydrofuran were placed in a reactor under a nitrogen atmosphere. After cooling to -78 °C, 152 mL (243 mmol) of 1.6 M n-butyllithium was slowly added dropwise, followed by stirring for 1 h. To the mixture was slowly added dropwise 37.7 g (221 mmol) of chlorodimethyl(phenyl)silane at the same temperature. The temperature was raised to room temperature. The resulting mixture was stirred for 2 h. After completion of the reaction, the organic layer was concentrated under reduced pressure and purified by column chromatography to afford 21.7 g of Intermediate 7-a (yield 35%).

### Synthesis Example 7-(2): Synthesis of Intermediate 7-b

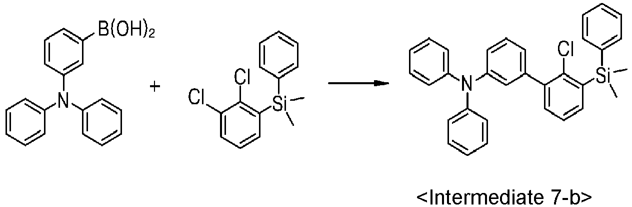

Intermediate 7-b was synthesized in the same manner as in Synthesis Example 1-(1), except that Intermediate 7-a was used instead of 1-bromo-2,3-dichlorobenzene (yield 75%).

### Synthesis Example 7-(3): Synthesis of Compound 40

Compound 40 was synthesized in the same manner as in Synthesis Example 1-(3), except that Intermediate 7-b was used instead of Intermediate 1-b (yield 26%).

MS (MALDI-TOF): m/z 463.19 [M⁺]

### Synthesis Example 8: Synthesis of Compound 49

### Synthesis Example 8-(1): Synthesis of Compound 49

Compound 49 (yield 24%) was synthesized in the same manner as in Synthesis Examples 1-(1) to 1-(3), except that 3-bromo-4,5-dichlorotoluene and 2-(dibenzo[b,d]furan-1-yl)-4,4,5,5-tetramethyl-1,3,2-dioxaborolane were used instead of 1-bromo-2,3-dichlorobenzene and 3-(diphenylamino)phenylboronic acid, respectively, in Synthesis Example 1-(1) and bis-(4-tert-butylphenyl)amine was used instead of diphenylamine in Synthesis Example 1-(2).

MS (MALDI-TOF): m/z 545.29 [M⁺]

### Synthesis Example 9: Synthesis of Chemical Compound 70

### Synthesis Example 9-(1): Synthesis of Compound 70

Compound 70 (yield 25%) was synthesized in the same manner as in Synthesis Examples 1-(1) to 1-(3), except that 3,4,5-trichlorobiphenyl-2',3',4',5',6'-d5 and 4-(4-tert-butylphenyl)phenylboronic acid were used instead of 1-bromo-2,3-dichlorobenzene and 3-(diphenylamino)phenylboronic acid, respectively, in Synthesis Example 1-(1) and bis-(4-tert-butylphenyl)amine was used instead of diphenylamine in Synthesis Example 1-(2).

MS (MALDI-TOF): m/z 654.74 [M⁺]

### Synthesis Example 10: Synthesis of Compound 91

### Synthesis Example 10-(1): Synthesis of Intermediate 10-a

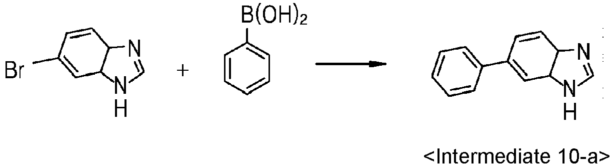

30 g (150 mmol) of 6-bromobenzimidazole, 18.3 g (150 mmol) of phenylboronic acid, 3.5 g (3.0 mmol) of tetrakis(triphenylphosphine)palladium, 41.6 g (301 mmol) of potassium carbonate, 150 mL of toluene, 150 mL of 1,4-dioxane, and 90 mL of water were placed in a reactor under a nitrogen atmosphere. The mixture was stirred under reflux for 12 h. After completion of the reaction, the reaction mixture was allowed to stand for layer separation. The organic layer was concentrated under reduced pressure and purified by column chromatography to afford 21.3 g of Intermediate 10-a (yield 72%).

### Synthesis Example 10-(2): Synthesis of Intermediate 10-b

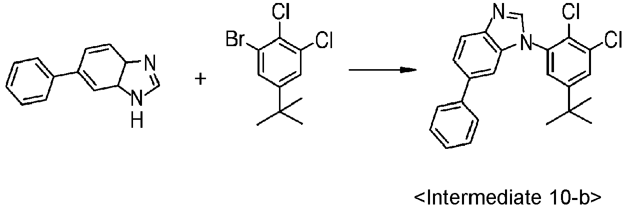

21.3 g (108 mmol) of Intermediate 10-a, 30.6 g (108 mmol) of 1-bromo-2,3-dichloro-5-tert-butylbenzene, 2.0 g (2.1 mmol) of tris(dibenzylideneacetone)dipalladium, 31.3 g (325 mmol) of sodium tert-butoxide, 2.7 g (4.3 mmol) of 2,2'-bis(diphenylphosphino)-1,1'-binaphthyl, and 200 mL of toluene were placed in a reactor. The mixture was stirred under reflux for 12 h. After completion of the reaction, the reaction mixture was allowed to stand for layer separation. The organic layer was concentrated under reduced pressure and purified by column chromatography to afford 27.9 g of Intermediate 10-b (yield 65%).

### Synthesis Example 10-(3): Synthesis of Intermediate 10-c

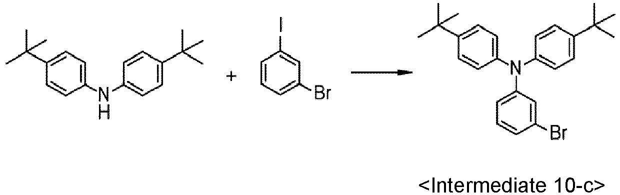

Intermediate 10-c (yield 68%) was synthesized in the same manner as in Synthesis Example 10-(2), except that bis(4-tert-butylphenyl)amine and 1-bromo-3-iodobenzene were used instead of Intermediate 10-a and 1-bromo-2,3-dichloro-5-tert-butylbenzene, respectively.

### Synthesis Example 10-(4): Synthesis of Intermediate 10-d

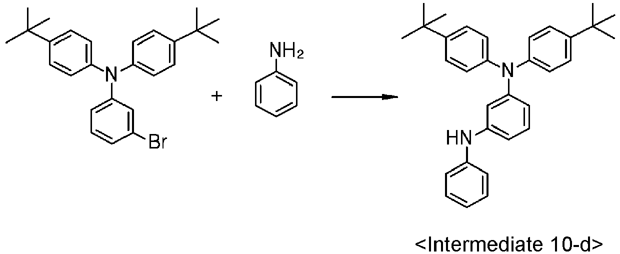

Intermediate 10-d (yield 70%) was synthesized in the same manner as in Synthesis Example 10-(2), except that Intermediate 10-c and aniline were used instead of Intermediate 10-a and 1-bromo-2,3-dichloro-5-tert-butylbenzene, respectively.

### Synthesis Example 10-(5): Synthesis of Intermediate 10-e

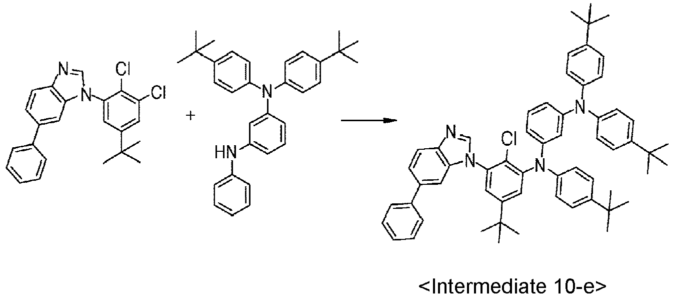

30 g (75.8 mmol) of Intermediate 10-b, 34.0 g (75.8 mmol) of Intermediate 10-d, 1.3 g (1.5 mmol) of tris(dibenzylideneacetone)dipalladium, 21.9 g (227 mmol) of sodium tert-butoxide, 0.6 g (3.0 mmol) of tri-tert-butylphosphine, and 300 mL of toluene were placed in a reactor. The mixture was stirred under reflux for 12 h. After completion of the reaction, the reaction mixture was allowed to stand for layer separation. The organic layer was concentrated under reduced pressure and purified by column chromatography to afford 50.2 g of Intermediate 10-e (yield 82%).

### Synthesis Example 10-(6): Synthesis of Compound 91

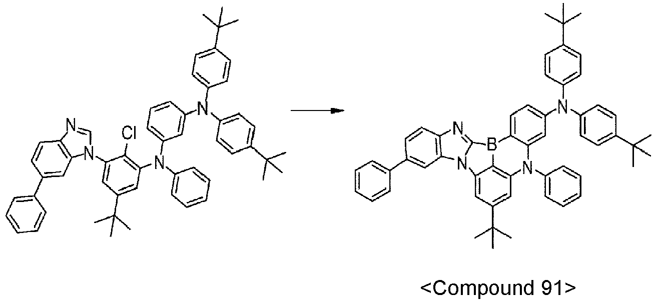

30 g (37.1 mmol) of Intermediate 10-e and 300 mL of tert-butylbenzene were placed in a reactor. The mixture was stirred under a nitrogen atmosphere. The temperature was lowered to 0 °C. After dropwise addition of 54.6 mL (92.8 mmol) of 1.7 M tert-butyllithium, stirring was continued at 60 °C for 3 h. The temperature was lowered to -30 °C. To the resulting mixture was added 18.6 g (74.3 mmol) of boron tribromide, followed by stirring at room temperature for 1 h. After addition of 9.6 g (74.3 mmol) of diisopropylethylamine, stirring was continued at 120 °C for 3 h. After completion of the reaction, the reaction mixture was allowed to stand for layer separation. The organic layer was concentrated under reduced pressure, purified by column chromatography, and recrystallized to give 5.2 g of Compound 91 (yield 18%).

MS (MALDI-TOF): m/z 780.44 [M⁺]

### Synthesis Example 11: Synthesis of Compound 92

### Synthesis Example 11-(1): Synthesis of Compound 92

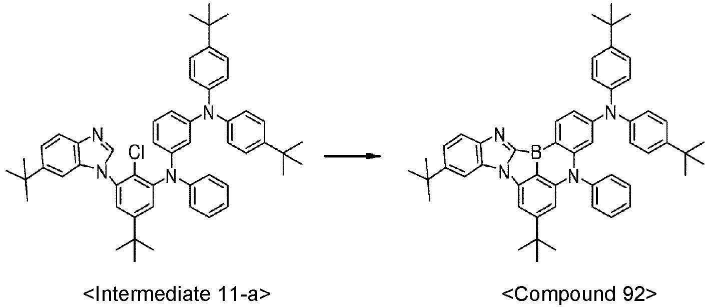

Intermediate 11-a was synthesized in the same manner as in Synthesis Examples 10-(1) to 10-(5), except that 6-tert-butylbenzimidazole was used instead of Intermediate 10-a in Synthesis Example 10-(2).

Compound 92 (yield 20%) was synthesized in the same manner as in Synthesis Example 10-(6), except that Intermediate 11-a was used instead of Intermediate 10-e.

MS (MALDI-TOF): m/z 760.47 [M⁺]

### Synthesis Example 12: Synthesis of Compound 94

### Synthesis Example 12-(1): Synthesis of Intermediate 12-a

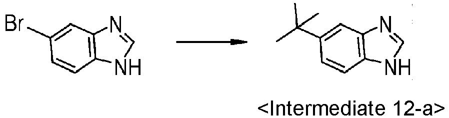

50 g (253 mmol) of 5-bromobenzimidazole, 8.3 g (12.6 mmol) of di(triphenylphosphine)nickel dichloride, and 500 ml of tetrahydrofuran were placed in a reactor. The mixture was stirred under a nitrogen atmosphere. To the mixture was added dropwise 49.2 g (304 mmol) of tertbutylmagnesium bromide at 0 °C. The resulting mixture was stirred under reflux for 12 h. After completion of the reaction, the reaction mixture was allowed to stand for layer separation. The organic layer was concentrated under reduced pressure and purified by column chromatography to afford 28.7 g of Intermediate 12-a (yield 65%).

### Synthesis Example 12-(2): Synthesis of Intermediate 12-b

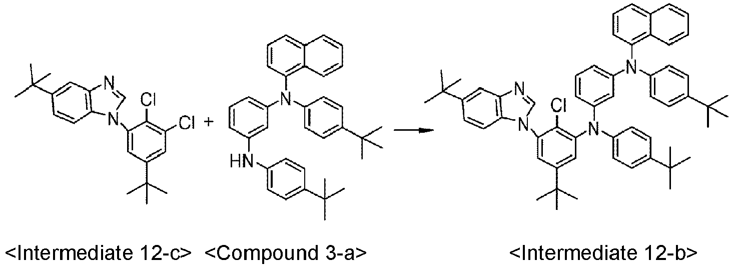

Intermediate 12-c was synthesized in the same manner as in Synthesis Example 10-(2) for the synthesis of Intermediate 10-b, except that Intermediate 12-a was used instead of Intermediate 10-a.

Intermediate 12-b (yield 77%) was synthesized in the same manner as in Synthesis Example 10-(5), except that Intermediate 12-c and Compound 3-a were used instead of Intermediate 10-b and Intermediate 10-d, respectively.

### Synthesis Example 12-(3): Synthesis of Compound 94

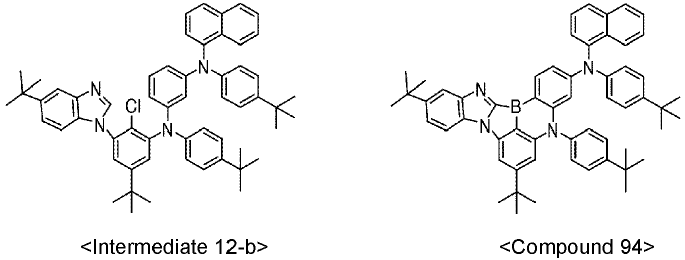

Compound 94 was synthesized in the same manner as in Synthesis Example 10-(6), except that Intermediate 12-b was used instead of Intermediate 10-e.

MS (MALDI-TOF): m/z 810.48 [M⁺]

### Synthesis Example 13. Synthesis of Compound 121

### Synthesis Example 13-1. Synthesis of Intermediate 13-a

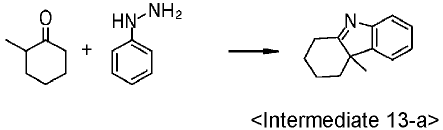

100 g (0.924 mol) of phenylhydrazine and 500 mL of acetic acid were stirred in a reactor. The mixture was heated to 60 °C. After 103.6 g (0.924 mol) of 2-methylcyclohexanone was slowly added dropwise, the resulting mixture was refluxed for 8 h. After completion of the reaction, the reaction mixture was extracted with water and ethyl acetate, concentrated, and purified by column chromatography to afford 130 g of Intermediate 13-a (yield 76%).

### Synthesis Example 13-2. Synthesis of Intermediate 13-b

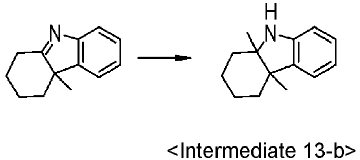

75 g (405 mmol) of Intermediate 13-a was added to 750 mL of toluene in a reactor under a nitrogen atmosphere. The mixture was cooled to -10 °C and then 380 mL (608 mmol) of 1.6 M methyllithium was slowly added dropwise thereto. The resulting mixture was stirred at -10 °C for ~3 h. After completion of the reaction, the reaction mixture was extracted using water and ethyl acetate, concentrated, and purified by column chromatography to afford 50.5 g of Intermediate 13-b (yield 62%).

### Synthesis Example 13-3. Synthesis of Intermediate 13-c

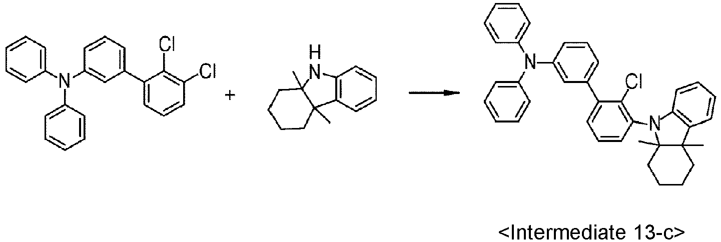

Intermediate 13-c (yield 78%) was synthesized in the same manner as in Synthesis Example 1-(2), except that Intermediate 13-b was used instead of diphenylamine.

### Synthesis Example 13-4. Synthesis of Compound 121

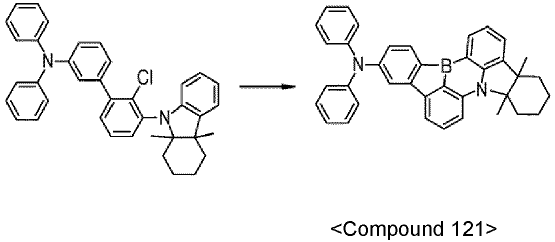

Compound 121 (yield 24%) was synthesized in the same manner as in Synthesis Example 1-(3), except that Intermediate 13-c was used instead of Intermediate 1-b.

MS (MALDI-TOF): m/z 528.27 [M⁺]

### Examples 1-28: Fabrication of organic electroluminescent devices

ITO glass was patterned to have a light emitting area of 2 mm × 2 mm, followed by cleaning. After the cleaned ITO glass was mounted in a vacuum chamber, DNTPD (700 Å) and α-NPD (300 Å) were deposited in this order on the ITO glass. The host compound and the inventive dopant compound shown in Table 1 were mixed in a weight ratio of 97:3. The mixture was used to form a 250 Å thick light emitting layer. Thereafter, the compound of Formula E-1 was used to form a 300 Å thick electron transport layer on the light emitting layer. Liq was used to form a 10 Å thick electron injecting layer on the electron transport layer. AI was deposited on the electron injecting layer to form a 1000 Å thick cathode, completing the fabrication of an organic electroluminescent device. The luminescent properties of the organic electroluminescent device were measured at 10 mA/cm².

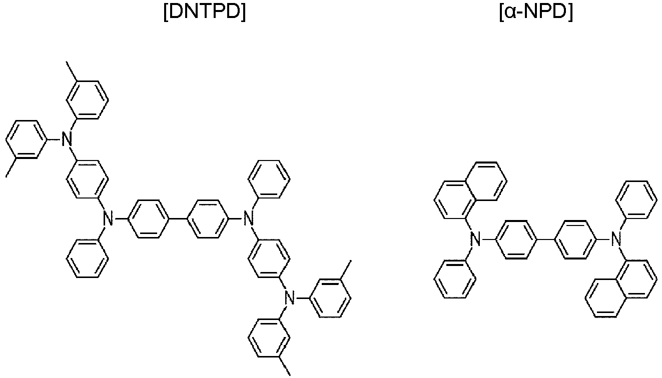

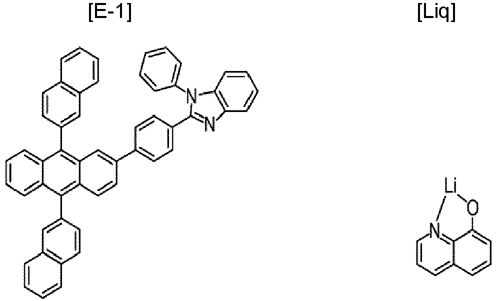

### Comparative Examples 1-4

Organic electroluminescent devices were fabricated in the same manner as in Examples 1-28, except that BD1 or BD2 was used instead of the dopant compound. The luminescent properties of the organic electroluminescent devices were measured at 10 mA/cm². The structures of BD1 and BD2 are as follow:

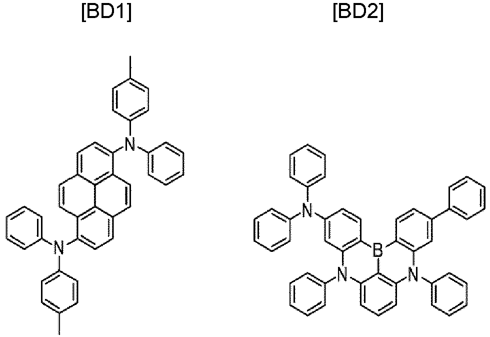

**[Table 1]**

| Example No. | Host | Dopant | EQE | T97 (h) |
|---|---|---|---|---|
| Example 1 | H103 | 1 | 8.6 | 165 |
| Example 2 | H227 | 1 | 8.8 | 178 |
| Example 3 | H103 | 2 | 8.7 | 158 |
| Example 4 | H227 | 2 | 8.8 | 167 |
| Example 5 | H103 | 7 | 8.9 | 160 |
| Example 6 | H227 | 7 | 9.2 | 165 |
| Example 7 | H103 | 19 | 8.8 | 145 |
| Example 8 | H227 | 19 | 9.0 | 160 |
| Example 9 | H103 | 24 | 8.9 | 150 |
| Example 10 | H227 | 24 | 9.2 | 165 |
| Example 11 | H103 | 30 | 9.0 | 137 |
| Example 12 | H227 | 30 | 9.1 | 146 |
| Example 13 | H103 | 40 | 8.9 | 135 |
| Example 14 | H227 | 40 | 9.1 | 144 |
| Example 15 | H103 | 49 | 8.9 | 129 |
| Example 16 | H227 | 49 | 9.2 | 151 |
| Example 17 | H103 | 70 | 9.1 | 172 |
| Example 18 | H227 | 70 | 9.4 | 187 |
| Example 19 | H103 | 73 | 8.8 | 143 |
| Example 20 | H227 | 73 | 9.0 | 161 |
| Example 21 | H129 | 91 | 8.7 | 155 |
| Example 22 | H244 | 91 | 8.9 | 164 |
| Example 23 | H129 | 92 | 8.9 | 161 |
| Example 24 | H244 | 92 | 9.1 | 169 |
| Example 25 | H129 | 94 | 8.6 | 142 |
| Example 26 | H244 | 94 | 8.8 | 148 |
| Example 27 | H129 | 121 | 8.8 | 150 |
| Example 28 | H244 | 121 | 9.0 | 158 |
| Comparative Example 1 | 103 | BD 1 | 5.7 | 83 |
| Comparative Example 2 | 227 | BD 1 | 5.9 | 88 |
| Comparative Example 3 | 103 | BD 2 | 7.1 | 92 |
| Comparative Example 4 | 227 | BD 2 | 7.3 | 95 |

As can be seen from the results in Table 1, the devices of Examples 1-28, each of which employed the inventive compound for the light emitting layer, showed high external quantum efficiency and significantly improved life characteristics compared to the devices of Comparative Examples 1-4.

## Claims

1. An organic electroluminescent compound represented by Formula A: 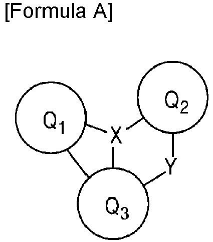 wherein Q₁ to Q₃ are identical to or different from each other and are each independently a substituted or unsubstituted C₆-C₅₀ aromatic hydrocarbon ring or a substituted or unsubstituted C₂-C₅₀ aromatic heterocyclic ring, Y is a single bond or is selected from NR₁, CR₂R₃, O, S, and SiR₄R₅ (provided that when Y is present in plurality, the linkers Y are identical to or different from each other), X is selected from B, P, P=O and P=S, and R₁ to R₅ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that each of R₁ to R₅ is optionally bonded to one or more of the rings Q₁ to Q₃ to form an alicyclic or aromatic monocyclic or polycyclic ring, R₂ and R₃ are optionally linked together to form an alicyclic or aromatic monocyclic or polycyclic ring, and R₄ and R₅ are optionally linked together to form an alicyclic or aromatic monocyclic or polycyclic ring, the "substituted" in the definition of Q₁ to Q₃ and R₁ to R₅ indicating substitution with one or more substituents selected from deuterium, cyano, halogen, hydroxyl, nitro, C₁-C₂₄ alkyl, C₃-C₃₀ cycloalkyl, C₁-C₂₄ haloalkyl, C₂-C₂₄ alkenyl, C₂-C₂₄ alkynyl, C₁-C₂₄ heteroalkyl, C₆-C₂₄ aryl, C₇-C₂₄ arylalkyl, C₇-C₂₄ alkylaryl, C₂-C₂₄ heteroaryl, C₂-C₂₄ heteroarylalkyl, C₁-C₂₄ alkoxy, C₁-C₂₄ alkylamino, C₆-C₂₄ arylamino, C₁-C₂₄ heteroarylamino, C₁-C₂₄ alkylsilyl, C₆-C₂₄ arylsilyl, and C₆-C₂₄ aryloxy.

2. The organic electroluminescent compound according to claim 1, wherein the compound of Formula A is represented by Formula A-1: 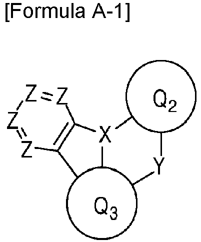 wherein each Z is independently CR or N, each R is independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that the groups R are optionally bonded to each other to form an alicyclic or aromatic monocyclic or polycyclic ring or each of the groups R is optionally linked to an adjacent substituent to form an alicyclic or aromatic monocyclic or polycyclic ring and that the alicyclic or aromatic monocyclic or polycyclic ring is optionally interrupted by one or more heteroatoms selected from N, S, and O, and X, Y, Q₂, and Q₃ are as defined in Formula A.

3. The organic electroluminescent compound according to claim 2, wherein the compound of Formula A-1 is represented by Formula A-2: 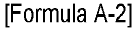 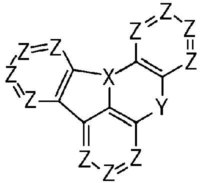 wherein X, Y, and Z are as defined in Formula A-1.

4. The organic electroluminescent compound according to claim 1, wherein the compound of Formula A is represented by Formula B-1: 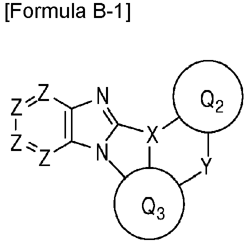 wherein each Z is independently CR or N, each R is independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that the groups R are optionally bonded to each other to form an alicyclic or aromatic monocyclic or polycyclic ring or each of the groups R is optionally linked to an adjacent substituent to form an alicyclic or aromatic monocyclic or polycyclic ring and that the alicyclic or aromatic monocyclic or polycyclic ring is optionally interrupted by one or more heteroatoms selected from N, S, and O, and X, Y, Q₂, and Q₃ are as defined in Formula A.

5. The organic electroluminescent compound according to claim 4, wherein the compound of Formula B-1 is represented by Formula B-2: 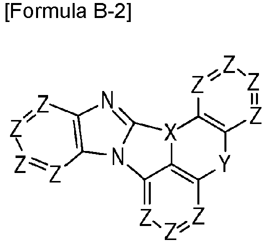 wherein X, Y, and Z are as defined in Formula B-1.

6. The organic electroluminescent compound according to claim 4, wherein at least one of the groups R is selected from substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen.

7. The organic electroluminescent compound according to claim 1, wherein each of R₁ to R₅ is optionally bonded to one or more of the rings Q₂ and Q₃ to form an alicyclic or aromatic monocyclic or polycyclic ring.

8. The organic electroluminescent compound according to claim 1, wherein the compound of Formula A is selected from Compounds 1 to 141:

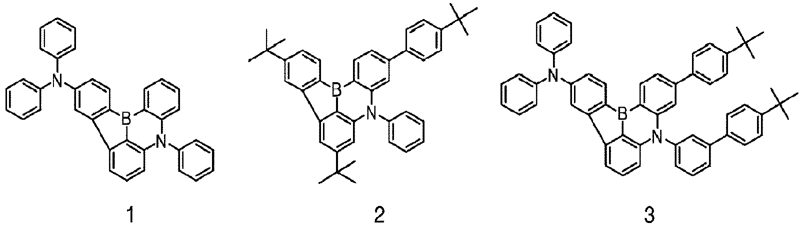

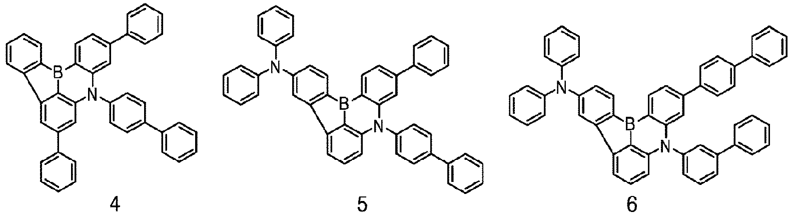

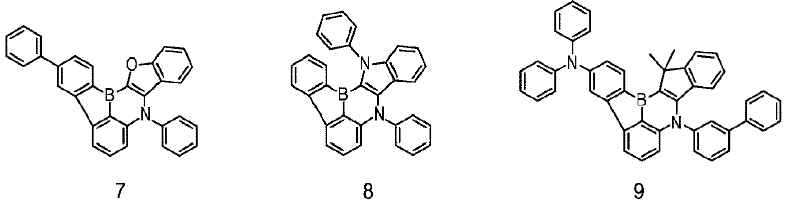

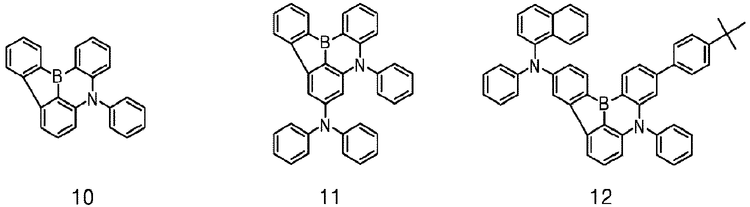

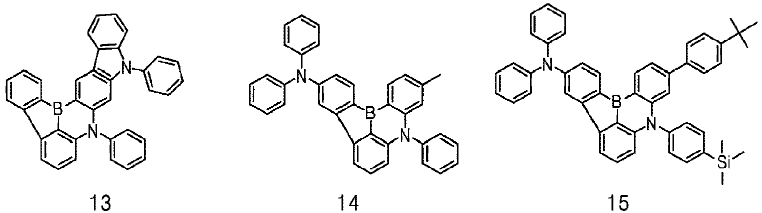

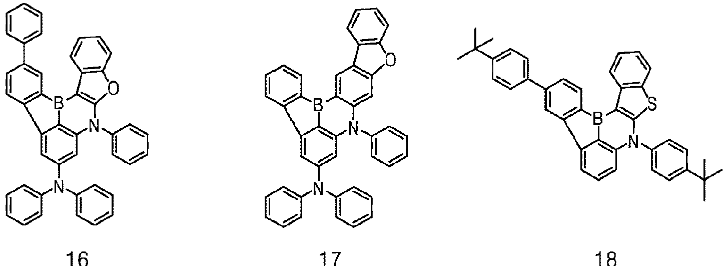

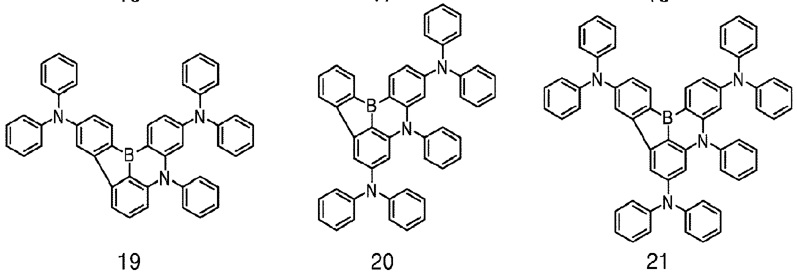

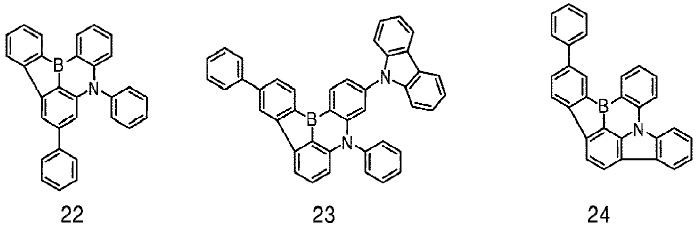

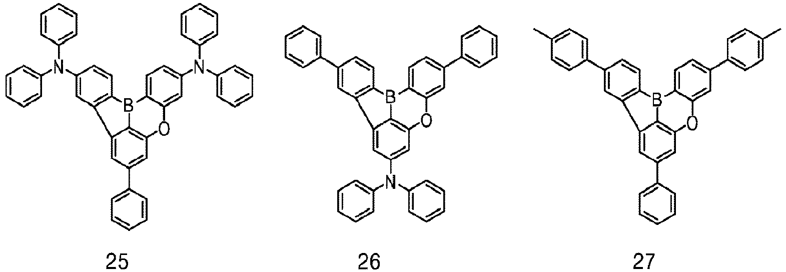

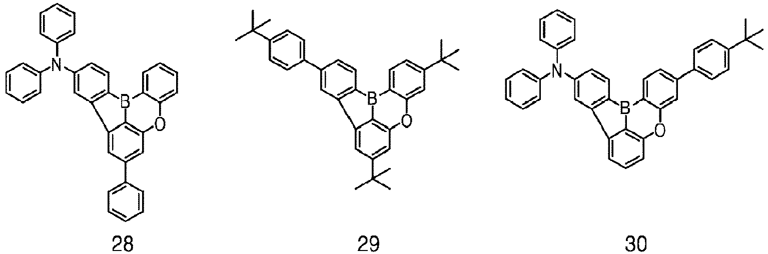

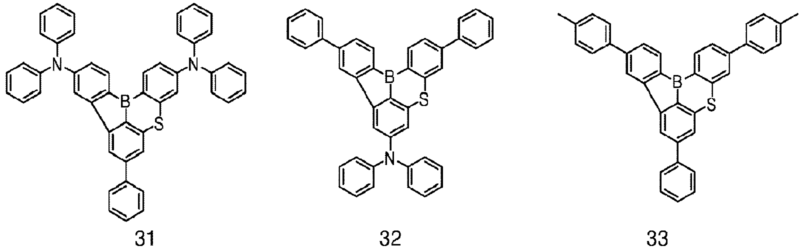

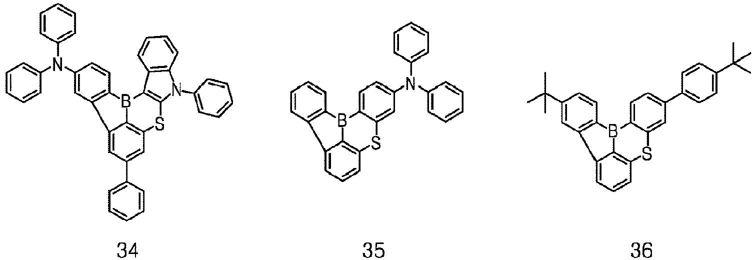

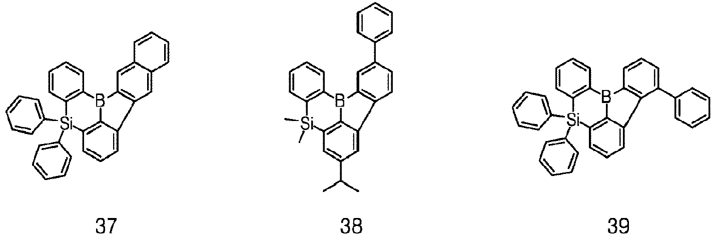

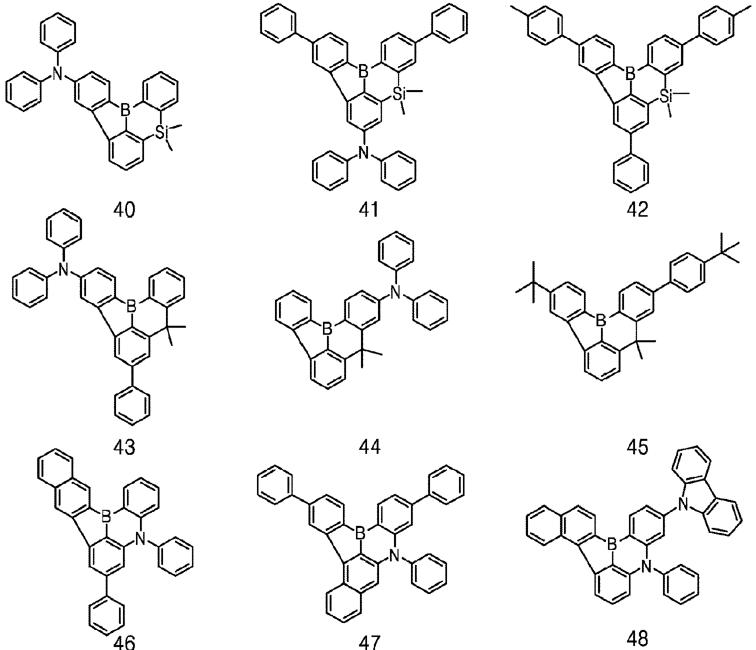

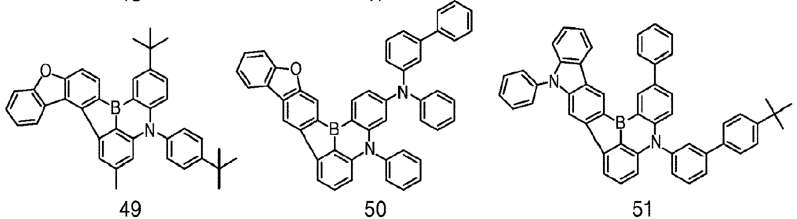

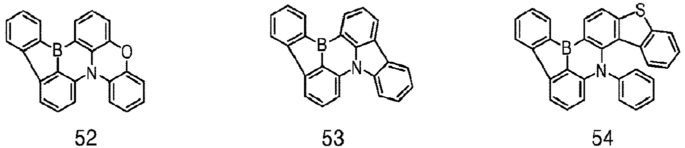

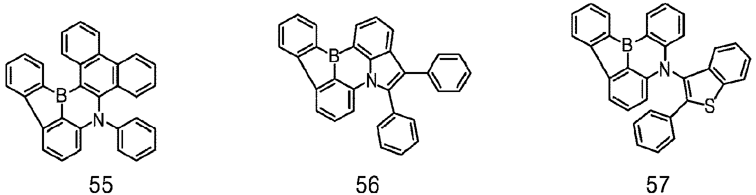

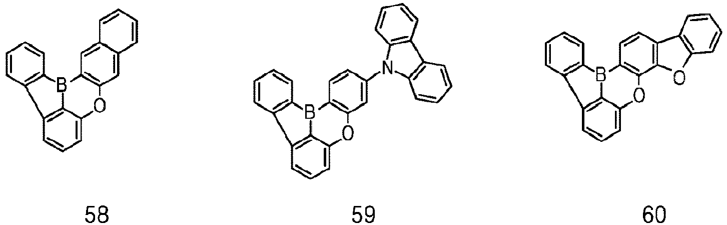

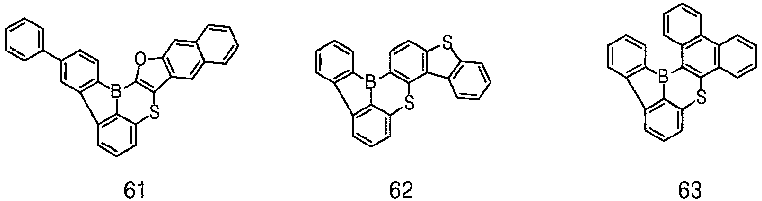

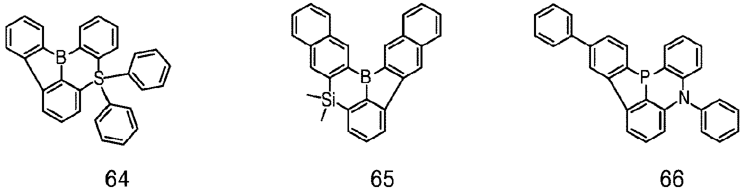

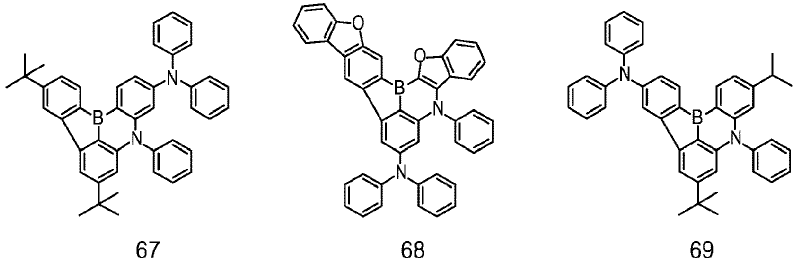

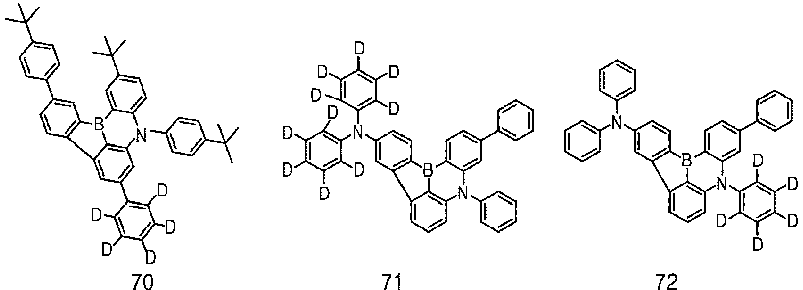

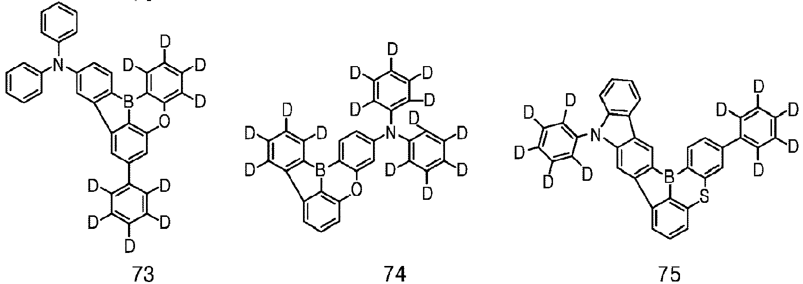

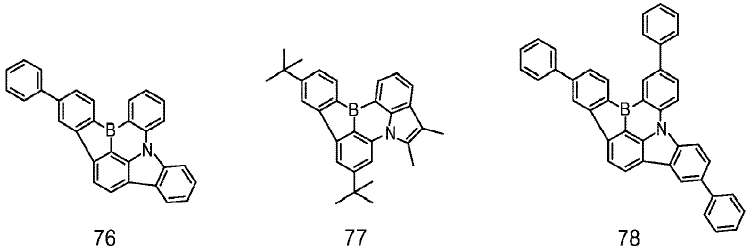

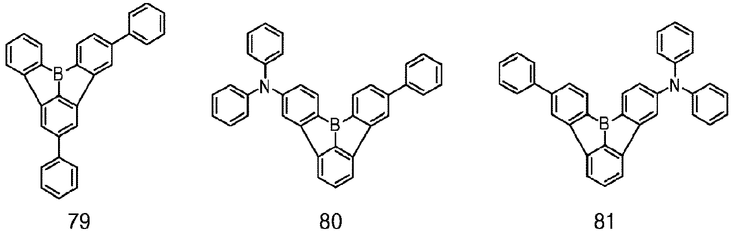

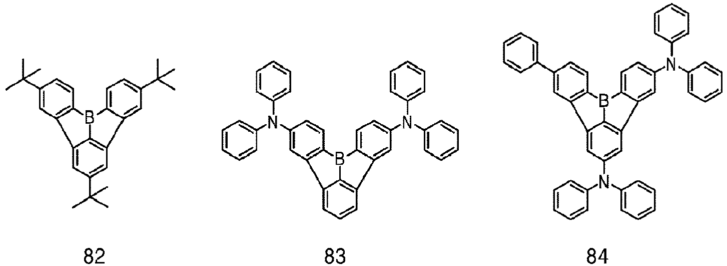

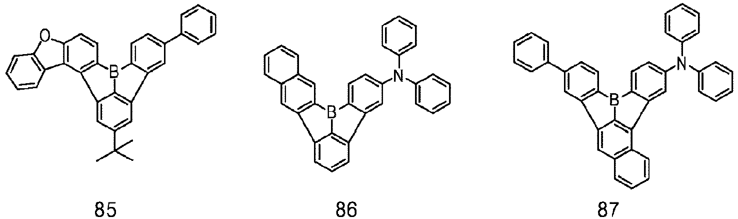

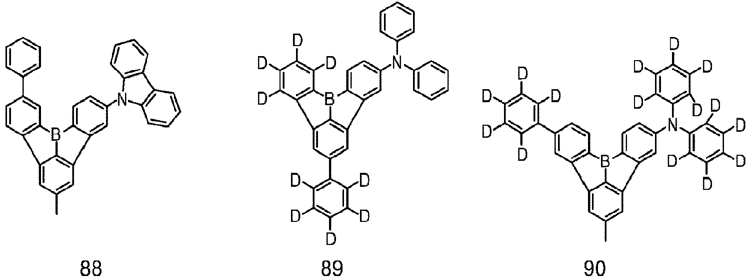

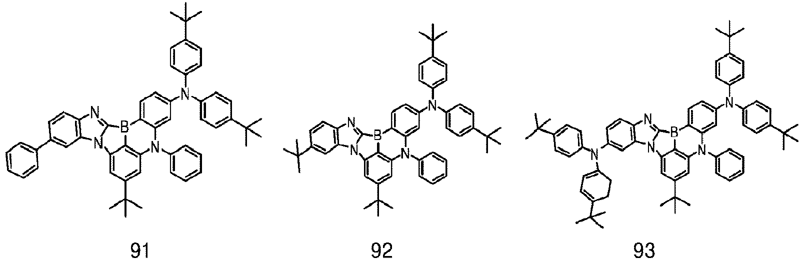

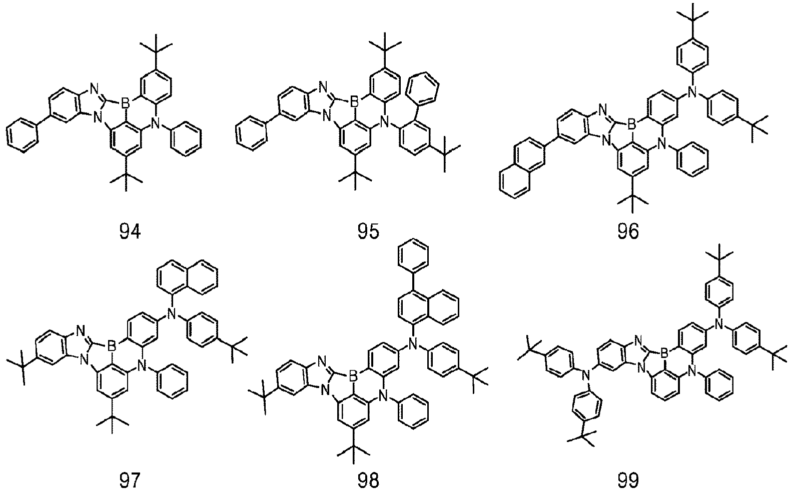

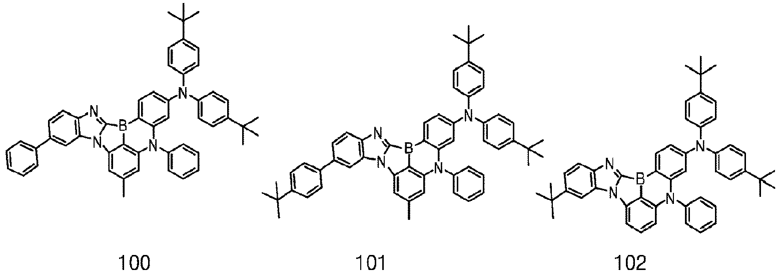

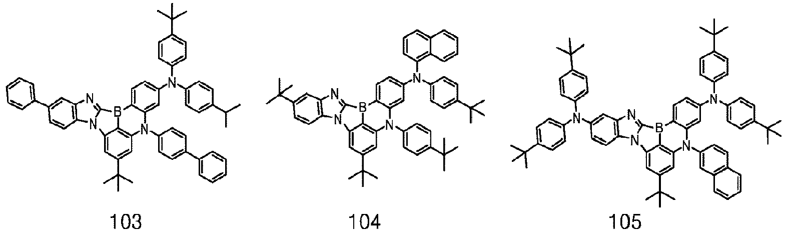

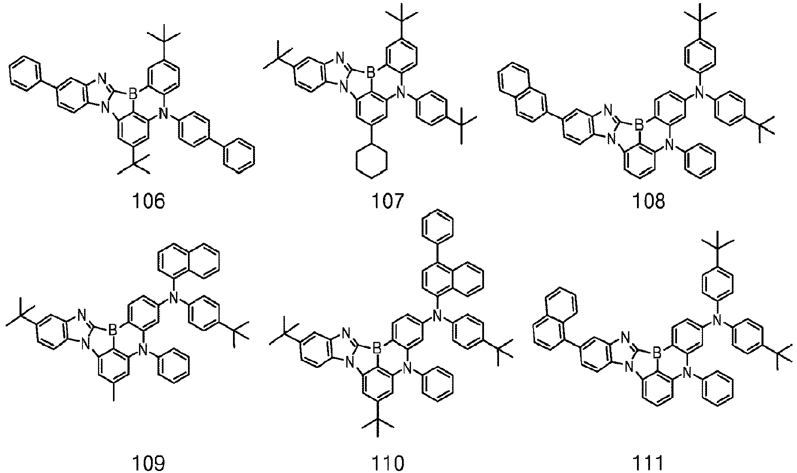

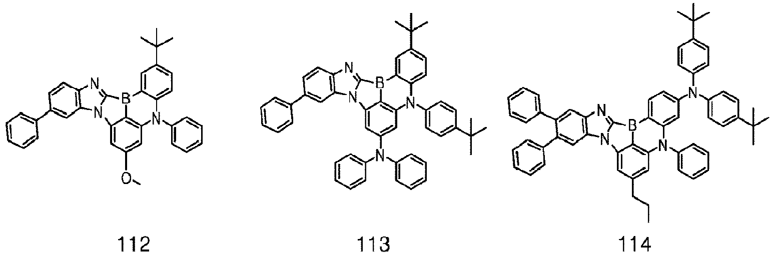

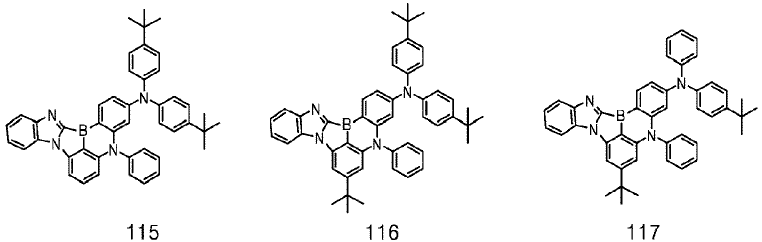

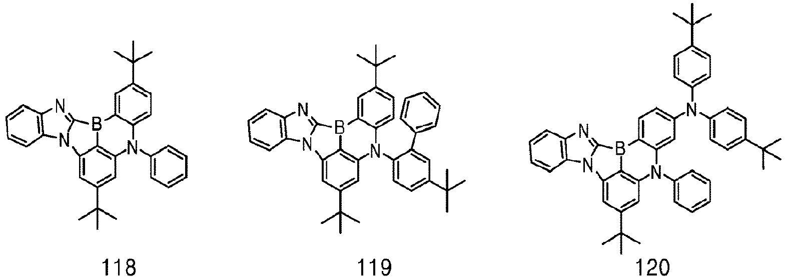

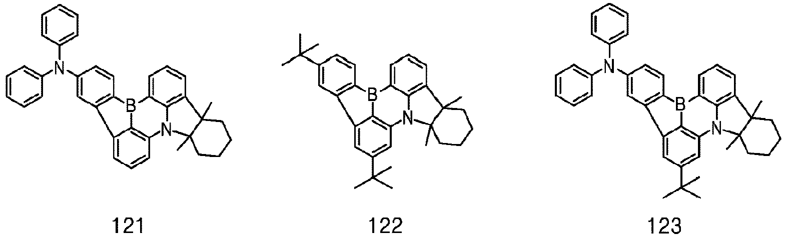

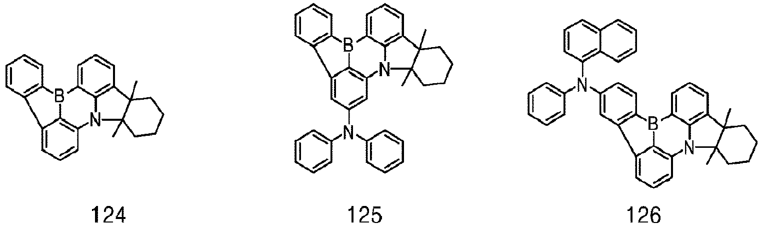

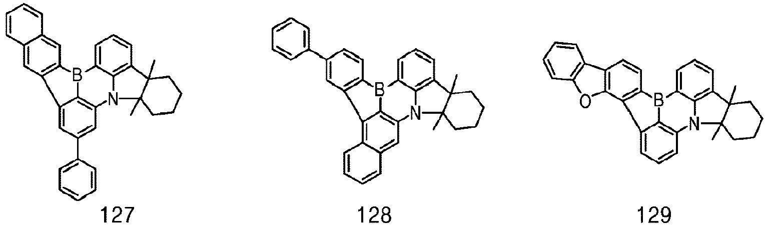

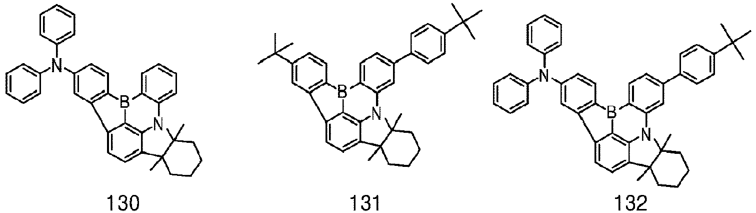

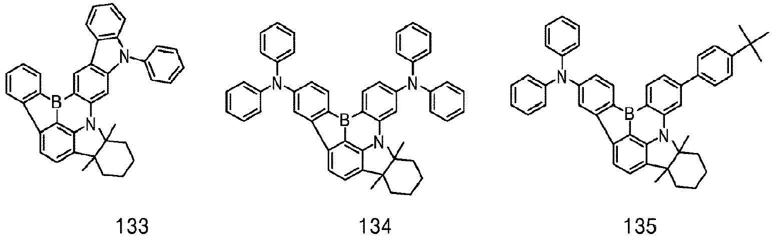

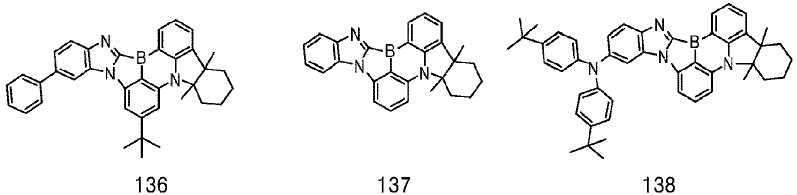

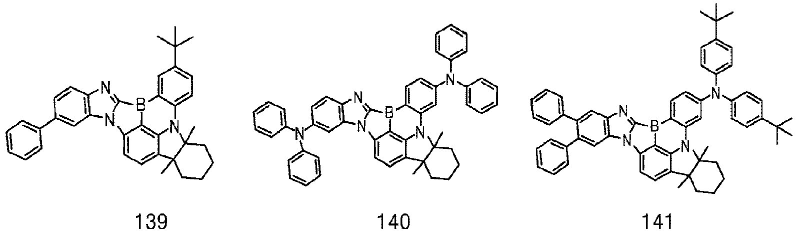

9. An organic electroluminescent device comprising a first electrode, a second electrode opposite to the first electrode, and one or more organic layers interposed between the first and second electrodes wherein one of the organic layers comprises the compound according to claim 1.

10. The organic electroluminescent device according to claim 9, wherein the organic layers comprise at least one layer selected from a hole injecting layer, a hole transport layer, a hole blocking layer, a light emitting layer, an electron blocking layer, an electron transport layer, and an electron injecting layer.

11. The organic electroluminescent device according to claim 10, wherein the light emitting layer is composed a host and the compound represented by Formula A as a dopant.

12. The organic electroluminescent device according to claim 10, wherein the light emitting layer further comprises a compound represented by Formula H1: 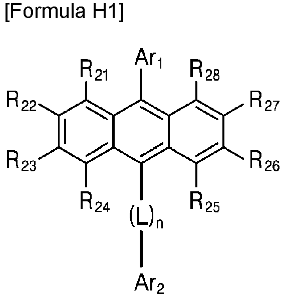 wherein R₂₁ to R₂₈ are identical to or different from each other and are each independently selected from the group consisting of hydrogen, deuterium, substituted or unsubstituted C₁-C₃₀ alkyl, substituted or unsubstituted C₂-C₃₀ alkenyl, substituted or unsubstituted C₃-C₃₀ cycloalkyl, substituted or unsubstituted C₅-C₃₀ cycloalkenyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₆-C₅₀ aryl, substituted or unsubstituted C₂-C₅₀ heteroaryl, substituted or unsubstituted silicon, substituted or unsubstituted boron, substituted or unsubstituted silane, carbonyl, phosphoryl, amino, nitrile, hydroxyl, nitro, halogen, amide, and ester, with the proviso that R₂₁ to R₂₈ are optionally bonded to each other to form a fused aliphatic, aromatic, heteroaliphatic or heteroaromatic ring or each of R₂₁ to R₂₈ is optionally linked to an adjacent substituent to form a fused aliphatic, aromatic, heteroaliphatic or heteroaromatic ring, Ar₁ and Ar₂ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₁-C₃₀ alkylsilyl, and substituted or unsubstituted C₆-C₃₀ arylsilyl, L is a single bond or is substituted or unsubstituted C₆-C₂₀ arylene or substituted or unsubstituted C₂-C₂₀ heteroarylene, and n is an integer from 0 to 3.

13. The organic electroluminescent device according to claim 10, wherein the light emitting layer further comprises a compound represented by Formula H2: 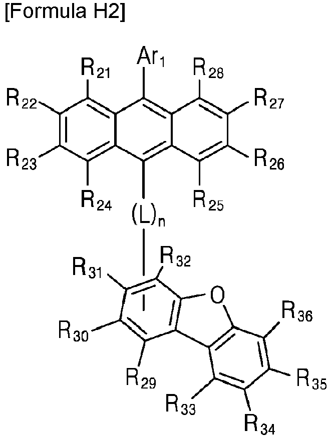 wherein R₂₁ to R₃₆ are identical to or different from each other and are each independently selected from the group consisting of hydrogen, deuterium, substituted or unsubstituted C₁-C₃₀ alkyl, substituted or unsubstituted C₂-C₃₀ alkenyl, substituted or unsubstituted C₃-C₃₀ cycloalkyl, substituted or unsubstituted C₅-C₃₀ cycloalkenyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₆-C₅₀ aryl, substituted or unsubstituted C₂-C₅₀ heteroaryl, substituted or unsubstituted silicon, substituted or unsubstituted boron, substituted or unsubstituted silane, carbonyl, phosphoryl, amino, nitrile, hydroxyl, nitro, halogen, amide, and ester, with the proviso that one of R₂₉ to R₃₂ is bonded to L and that R₂₁ to R₃₆ are optionally bonded to each other to form a fused aliphatic, aromatic, heteroaliphatic or heteroaromatic ring or each of R₂₁ to R₃₆ is optionally linked to an adjacent substituent to form a fused aliphatic, aromatic, heteroaliphatic or heteroaromatic ring, Ar₁ is selected from hydrogen, deuterium, substituted or unsubstituted C₁₋C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₁-C₃₀ alkylsilyl, and substituted or unsubstituted C₆-C₃₀ arylsilyl, L is a single bond or is substituted or unsubstituted C₆-C₂₀ arylene or substituted or unsubstituted C₂-C₂₀ heteroarylene, and n is an integer from 0 to 3.

14. The organic electroluminescent device according to claim 10, wherein each of the organic layers is formed by a deposition or solution process.

15. The organic electroluminescent device according to claim 9, wherein the organic electroluminescent device is used in a display or lighting system selected from flat panel displays, flexible displays, monochromatic flat panel lighting systems, white flat panel lighting systems, flexible monochromatic lighting systems, and flexible white lighting systems.
